# FASCICULE DE BREVET EUROPEEN

(11) **EP 1 634 341 B1**
(45) Date de publication et mention de la délivrance du brevet: **25.02.2015**
(21) Numéro de dépôt: 04767309.0
(22) Date de dépôt: 10.06.2004
(51) Int. Cl.: H01L 51/46, C01B 31/02, H01L 51/42

(54) **CELLULE PHOTOVOLTAIQUE COMPRENANT DE NANOTUBES DE CARBONE AYANT A SES SURFACES UN PIGMENT**
SOLARZELLE WELCHE AUS FARBSTOFFSENSIBILISIERTEN KOHLENSTOFFNANORÖHRCHEN AUFGEBAUT IST.
SOLAR CELL COMPRISING CARBON NANOTUBES HAVING A DYE ADSORBED ON THEIR SURFACE

(30) Priorité: 11.06.2003 FR 0306977
(43) Date de publication de la demande: 15.03.2006
(73) Titulaire: Nanoledge, 34830 Clapiers (FR)
(72) Inventeur: SAINTE CATHERINE, Julien, F-34470 Perols (FR); FRAYSSE, Jérôme, F-34090 Montpellier (FR)
(74) Mandataire: Mendelsohn, Isabelle M. N.
(86) Numéro de dépôt international: PCT/FR2004/001444
(87) Numéro de publication internationale: WO 2004/112163

(56) Documents cités:
- WO-A-02/100154
- PATENT ABSTRACTS OF JAPAN vol. 2003, no. 03, 5 mai 2003 (2003-05-05) & JP 2002 335004 A (OSAKA GAS CO LTD), 22 novembre 2002 (2002-11-22)
- KYMAKIS E ET AL: "High open-circuit voltage photovoltaic devices from carbon-nanotube-polymer composites" JOURNAL OF APPLIED PHYSICS, AMERICAN INSTITUTE OF PHYSICS. NEW YORK, US, vol. 93, no. 3, 1 février 2003 (2003-02-01), pages 1764-1768, XP012058984 ISSN: 0021-8979
- FENG W ET AL: "BROAD SPECTRAL SENSITIZATION OF ORGANIC PHOTOVOLTAIC HETEROJUNCTION DEVICE BY PERYLENE AND C60" JOURNAL OF APPLIED PHYSICS, AMERICAN INSTITUTE OF PHYSICS. NEW YORK, US, vol. 88, no. 12, 15 décembre 2000 (2000-12-15), pages 7120-7123, XP001162766 ISSN: 0021-8979
- TSUZUKI T ET AL: "The effect of fullerene doping on photoelectric conversion using titanyl phthalocyanine and a perylene pigment" SOLAR ENERGY MATERIALS AND SOLAR CELLS, ELSEVIER SCIENCE PUBLISHERS, AMSTERDAM, NL, vol. 61, no. 1, 15 février 2000 (2000-02-15), pages 1-8, XP004244744 ISSN: 0927-0248
- AGO H ET AL: "COMPOSITES OF CARBON NANOTUBES AND CONJUGATED POLYMERS FOR PHOTOVOLTAIC DEVICES" ADVANCED MATERIALS, VCH VERLAGSGESELLSCHAFT, WEINHEIM, DE, vol. 11, no. 15, 20 octobre 1999 (1999-10-20), pages 1281-1285, XP000869420 ISSN: 0935-9648

## Description

L'invention décrit des nanotubes de carbone, des dispersions de ces nanotubes, des matériaux composites et des articles en matériau composite comprenant ces nanotubes de carbone. Elle décrit également les procédés de fabrication de tels produits.

La présente invention concerne un dispositif constitué par une hétérojonction PN formée par au moins un polymère conjugué et au moins un type de nanostructure tubulaire de carbone particulière. Différents dispositifs sont proposés pour former une cellule photovoltaïque.

### ETAT DE LA TECHNIOUE :

Depuis leur découverte en 1991 (Iijima, S., Nature 354 (1991), 56-58) et grâce à leurs propriétés uniques, les nanotubes de carbone ont rapidement suscité l'intérêt des chercheurs. Leurs exceptionnelles élasticité et résistance à la traction, leurs très bonnes conductivités électrique et thermique ainsi que leurs stabilités chimique et thermique ouvrent aux nanotubes de nombreuses applications potentielles dans des secteurs aussi variés que l'électronique, le médical ou l'aéronautique.

Les propriétés des nanotubes de carbone ont été décrites de manière assez exhaustive dans le passé (R. Saito, G. Dresselhaus, M. S. Dresselhaus, "Physical Properties of Carbon Nanotubes", Impérial College Press, London U.K. 1998; J.-B. Donnet, T. K. Wang, J. C. M. Peng, S. Rebouillat [édi.], "Carbon Fibers", Marcel Dekker N.Y; USA 1998).

Les nanotubes de carbone mono-feuillets (SWNT) sont généralement synthétisés par des méthodes physiques (arc électrique ou laser) alors que les nanotubes de carbone multi-feuillets (MWNT) sont produits à partir d'une méthode chimique comprenant une décomposition de gaz hydrocarbures.

Le diamètre des nanotubes varie d'environ 0,4 nm à plus de 3 nm pour les SWNT et d'environ 1,4 nm à au moins 100 nm pour les MWNT (Z. K. Tang et al., Science 292, 2462 (2001) ; R. G. Ding, G. Q. Lu, Z. F. Yan, M. A. Wilson, J. Nanosci. Nanotechnol. 1, 7 (2001)).

Certains travaux ont également mis en évidence que l'incorporation de nanotubes de carbone dans des matières plastiques solides permet d'améliorer les propriétés mécaniques et électriques de ces matières plastiques solides (M. J. Biercuk et al., Appl. Phys.Lett. 80, 2767 (2002) ; D. Qian, E. C. Dickey, R. Andrews, T. Randell, Appl. Phys. Lett. 76, 2868 (2000)).

Les propriétés des nanotubes de carbone permettent de les utiliser pour des émetteurs d'électrons, des membranes ou des pointes pour la microscopie par force atomique.

De plus, les nanotubes peuvent contribuer à éviter un chargement électrostatique local, comme cela est observé pendant l'application de peinture sous forme de poudre sur une surface métallique ou plastique.

Afin de permettre une transmission des propriétés favorables des nanotubes de carbone au matériau solide auquel ils sont ajoutés, il est nécessaire d'arriver à répartir les nanotubes de manière homogène dans la matrice dont le matériau est constitué. Pour cela, il faut d'abord préparer des dispersions de nanotubes de carbone dans un milieu liquide. Pour que de telles dispersions soient stables, c'est-à-dire qu'il n'y ait pas d'agrégation ou de précipitation des nanotubes dans le milieu liquide, les forces adhésives entre les particules doivent être minimisées. En effet, les SWNT ainsi que les MWNT ont tendance à s'assembler sous forme de faisceaux contenant plusieurs nanotubes.

A cet effet, le demande de brevet WO02/076888 A1 décrit des suspensions de nanotubes de carbone dans un milieu liquide contenant jusqu'à 65% en poids de tubes de carbone revêtus de polymères. Cependant, ces suspensions sont uniquement des suspensions soit dans de l'eau pure soit dans des solutions aqueuses.

Or, il est nécessaire, en particulier, pour fabriquer des matériaux composites contenant des nanotubes d'obtenir des dispersions de nanotubes dans des solvants organiques liquides non solubles dans, ou non miscibles avec, l'eau.

Le brevet US 6 099 965 décrit de telles suspensions dans des solvants organiques, éventuellement en présence d'un dispersant, mais la concentration en nanotubes de carbone dans ces suspensions en milieu liquide organique ne dépasse pas 0,1% en poids.

Le brevet US 6 187 823 B1 décrit des solutions de nanotubes de carbone dissous dans un solvant organique. Mais d'une part, les nanotubes de carbone sont des nanotubes mono-feuillets qui ont été modifiés par attache à leur surface d'une amine ou d'une alkylarylamine et d'autre part, les propriétés intrinsèques des nanotubes sont altérées du fait de leur modification chimique en surface et de la destruction des liaisons carbone-carbone par greffage de groupes amine sur la structure.

En résumé, il existe actuellement des méthodes pour disperser des nanotubes dans des solvants aqueux en concentrations supérieures à 10 % mais aucune permettant de disperser des quantités supérieures à 0,1% en poids dans des solvants organiques non solubles dans, ou non miscibles avec, l'eau sans modifier chimiquement les nanotubes.

L'impossibilité actuelle de pouvoir disperser de telles quantités de nanotubes dans des solvants organiques non solubles dans, ou non miscibles avec, l'eau et par la suite d'intégrer ces nanotubes de manière homogène dans une matrice organique non miscible ou non soluble dans l'eau constitue un frein à l'utilisation de nanotubes de carbone comme charge.

D'autre part, les cellules photovoltaïques (dénommées également cellules solaires) sont l'un des plus intéressants moyens écologiques de conversion de l'énergie qui sont apparus dans les décennies passées. Des efforts considérables ont été effectués concernant le développement des cellules solaires. Ces cellules sont aujourd'hui utilisées comme éléments de produits électroniques de grande distribution, comme les calculatrices de poche. Bien que des progrès significatifs aient été accomplis dans le développement des cellules photovoltaïques, l'amélioration du rendement de conversion énergétique, le prolongement de la durée de vie et la réduction des coûts sont encore nécessaires afin d'ouvrir d'autres marchés, tels que celui des télécommunications, de l'automobile ou de la domotique.

Un état de l'art conséquent existe sur les cellules photovoltaïques basées sur les matériaux semi-conducteurs conventionnels, tels que le silicium, l'arséniure de gallium ou le sulfure de cadnium, etc... Dans ces dispositifs incluant une hétérojonction PN, la production de courant électrique est basée sur la dissociation des charges, induite par les photons, au niveau de la jonction. La production des matériaux semi-conducteurs utilisés dans ces dispositifs requiert des températures de fabrication élevées et les performances optimum des cellules photovoltaïques ne sont réalisées qu'en utilisant des matériaux mono cristallins. Ces contraintes technologiques augmentent directement ou indirectement les coûts de production, et contribuent grandement à réduire le champ d'applications des cellules photovoltaïques basées sur les matériaux semi-conducteurs.

La possibilité d'utiliser les polymères conjugués comme éléments actifs (structure donneuse d'électrons) des cellules photovoltaïques a été démontrée depuis le début des années 1980 (Propriétés photovoltaïques des polymères conjugués : B. R. Weinberger, S. C. Gau and Z. Kiss, Appl. Phys. Lett., 38, 555 (1981); R. N. Marks, J. J. M. Halls, D. D. C. Bradley, R. H Friend and A. B. Holmes, J. Phys.: Condens. Matter, 6, 1379 (1994)).

JP 2002/335004 divulgue une cellule solaire comprenant une hétérojonction qui comprend une structure donneuse d'électrons et une structure accepteuse d'électrons en contact l'une avec l'autre par un pigment et des liaisons covalentes.

Dans les matériaux organiques, l'absorption des photons engendre la création d'états excités et la génération de paires électron-trou : les excitons. Dans ce cas, la production de courant électrique requiert la dissociation des excitons suivie du transport des charges vers les électrodes opposées. L'utilisation de polymères conjugués peut présenter d'importants avantages. Par exemple, elle autorise un choix sur la largeur de la bande d'énergie interdite du polymère (soit par un choix judicieux du squelette conjugué, soit par des fonctionnalisations de chaînes branchées) et pourrait ainsi permettre d'ajuster le spectre d'absorption du polymère à celui du spectre solaire. La facilité de mise en oeuvre des polymères, et en particulier des polymères conjugués solubles, permet la fabrication de dispositifs de très grande surface; et des réductions de coûts importants seraient réalisées en comparaison des technologies existantes. Cependant ces systèmes souffrent d'un rendement plus faible et d'une durée de vie moindre que les dispositifs basés sur les matériaux semi-conducteurs mono cristallins.

Des améliorations des cellules photovoltaïques basées sur les polymères conjugués de type p (i.e se comportant comme des donneurs d'électrons) ont été proposés. Par exemple, les brevets U.S. 5,454,880 et U.S 5,986,206 décrivent respectivement l'incorporation de fullerènes et de petites particules de carbone agissant comme accepteurs d'électrons. Cependant les dispositifs décrits présentent l'inconvénient d'une dissipation limitée de la chaleur ainsi que d'une évacuation limitée des charges (en particulier des électrons) vers l'extérieur de la cellule, ce qui dégrade le polymère conducteur, limite la durée de vie des cellules photovoltaïques et restreint leur efficacité.

Les performances sont cependant restreintes par la dissociation limitée des excitons, le transport limité des charges vers les électrodes et la dissipation limitée de la chaleur vers l'extérieur de la cellule. Tous ces inconvénients limitent les dispositifs actuels à de faibles rendements photo-électriques.

### BUTS DE L'INVENTION :

Dans une première partie, l'invention décrit comment pallier les inconvénients de l'art antérieur en proposant de diminuer les interactions interparticulaires entre les nanotubes en les complexant afin d'obtenir des dispersions stables, homogènes et à concentration élevée de nanotubes de carbone, dans des milieux organiques non-miscibles dans l'eau.

Dans une seconde partie, la présente invention a principalement pour but de résoudre les nombreux problèmes techniques énoncés ci-dessus concernant la conversion photovoltaïque et notamment celui consistant en la fourniture d'un dispositif consistant en une hétérojonction PN comprenant au moins un polymère conjugué (fonctionnant comme une structure donneuse d'électrons) et au moins un type de nanostructure tubulaire de carbone (fonctionnant comme une structure accepteuse d'électrons), les nanostructures comprenant au moins un pigment directement adsorbé sur leur périphérie et au moins un polymère ayant un point d'ancrage sur la couche de pigment, le point d'ancrage consistant en des interactions de type Van der Waals permettant ainsi d'améliorer le rendement et la durée de vie des cellules.

La présente invention a aussi pour but de fournir des procédés de fabrication de tels dispositifs afin d'être utilisés comme élément de conversion photovoltaïque, notamment utilisé au sein de cellules photovoltaïques.

Le but de la présente invention est d'améliorer les performances en terme d'efficacité de conversion de l'énergie et de durée de vie des dispositifs photovoltaïques basés sur les polymères conjugués.

Cette invention permettra également d'élargir le champ d'applications de tels dispositifs grâce aux faibles coûts de production de telles cellules comparés aux autres méthodes connues.

La présente invention a également pour but l'amélioration des performances générales des cellules photovoltaïques basées sur des polymères conjugués.

L'amélioration des performances est notamment corrélée à la dissociation efficace des excitons.

Ceci implique la présence, en assez grand nombre, de centres de dissociation des excitons. Ces centres sont en général des entités accepteuses de charges électriques (électrons ou trous). Les centres de dissociation doivent être facilement accessibles pour les excitons. Ceci implique, d'une part, une bonne intimité entre les entités donneuses (chaînes de polymère conjugués et/ou pigments) et les centres de dissociation et, d'autre part, une taille préférée des centres de dissociation à l'échelle moléculaire, afin d'obtenir une très grande interface entre ces centres et les molécules donneuses. L'invention a pour but de résoudre ce problème technique.

Outre la dissociation des excitons, deux autres points sont cruciaux :
- Le transport efficace des charges vers les électrodes. Une fois que les excitons sont dissociés, il faut éviter leur recombinaison et assurer leur transport rapide vers les électrodes à travers des phases séparées.
- Enfin, la dissipation de la chaleur vers l'extérieur de la cellule doit être assurée. En effet la chaleur peut d'une part modifier les caractéristiques de la cellule (e.g en altérant la conformation des chaînes polymères) et d'autre part limiter la durée de vie des cellules en dégradant les chaînes polymères. La dissipation de la chaleur est donc un aspect crucial d'amélioration des cellules photovoltaïques basées sur les polymères conjugués.

L'invention a également pour but de fournir des éléments actifs de cellules photovoltaïques sous une forme qui permette la constitution de cellules photovoltaïques sous des formes et sur des supports de forme variée.

### DESCRIPTION DE L'INVENTION :

### Dans une première partie :

Dans le contexte de la présente invention le terme "nanotube" désigne un matériau à base de carbone comme les nanofibres de carbone droites et courbées, les nanotubes de carbone qui peuvent être mono-feuillets (SWNT), droits et courbés, ou double-feuillets (DWNT), droits et courbés, ou multi-feuillets (MWNT) droits et courbés aussi bien que les fibres de carbone dont la croissance a été effectuée en phase vapeur (VGCF) et toutes les structures carbonées cylindriques ou tubulaires. Dans ce qui suit, on désignera par les termes "nanotubes muti-feuillets" aussi bien les nanotubes double-feuillets que les nanotubes constitués de trois feuillets et plus. Le terme "nanotube" désigne également un mélange de nanotubes de carbone avec un ou plusieurs composants, tels que le carbone amorphe, le graphite ou un catalyseur (forme sous laquelle on retrouve les nanotubes après production).

Par dispersion stable, dans le cadre de la présente invention, il faut comprendre des dispersions ne présentant ni réagrégation ni reprécipitation des nanotubes de carbone dans la dispersion au bout d'au moins quatre jours de stockage à température ambiante.

Par répartition de manière homogène des nanotubes dans la dispersion, dans le cadre de la présente invention, il faut comprendre que les nanotubes ne forment que peu ou pas d'agrégats et qu'au cas où de tels agrégats sont formés, ces agrégats sont de préférence très petits : inférieurs à 1 µm², et qu'ils sont répartis dans l'ensemble de la dispersion.

Par nanotubes "nus", dans le cadre de la présente description, il faut comprendre des nanotubes n'ayant subi aucun traitement de modification de leur surface, que ce soit chimique ou par complexation.

Ainsi, **dans** un premier objet, l'invention décrit des nanotubes de carbone complexés utilisables dans le cadre de la présente invention et constitués de nanotubes de carbone nus comportant une couche d'au moins un pigment directement adsorbée sur leur périphérie externe, et au moins un polymère ayant au moins un point d'ancrage sur ladite couche d'au moins un pigment, le point d'ancrage consistant en des interactions de type Van der Waals.

Selon l'invention, les nanotubes peuvent être des nanotubes mono-feuillets (SWNT), des nanotubes double-feuillets (DWNT), des nanotubes multi-feuillets (MWNT), des nanotubes dont la croissance a été effectuée en phase vapeur (VGCF), des nanofibres, ou une structure carbonée cylindrique et leurs mélanges.

De préférence, les nanotubes sont des nanotubes mono-feuillets, des nanotubes double-feuillets, des nanotubes multi-feuillets ou leurs mélanges.

Encore plus préférablement, les nanotubes sont des nanotubes mono-feuillets.

Quant au pigment, il peut être un pigment organique, tel que les pigments azo, les pigments monoazo jaune et orange, les pigments diazo, les pigments napthol, les pigments napthol AS (napthol rouge) les laques de pigment azo, les pigments benzimidazolone, les pigments de condensation diazo, les pigments complexes de métal, les pigments isoindolinone et isoindoline, les pigments polycycliques, les pigments phthalocyanine, une phthalocyanine de cuivre sulfonée contenant, en moyenne, 0,5 à 3 groupes d'acide sulfonique, une pthalocyanine de cuivre chlorée broyée, une phthalocyanine d'aluminium, une phthalocyanine bromée, une pthalocyanine d'hydroxyde d'aluminium, une pthalocyanine sans métal, les pigments quinophthalone, les pigments indathrone, les pigments diacrylide jaune, les pigments diazopyrozolione, les pigments azo-métal, les pigments triarylcarbonium, les pigments rhodamine laque, les pigments pérylène, les pigments quinacridone et les pigments dicétopyrrolopyrrole et les mélanges de deux ou plus de ceux-ci.

De préférence, le pigment est la phtalocyanine.

Quant au polymère, il est choisi dans le groupe constitué par les polymères d'un ou plusieurs acides organiques ou acides hydroxyliques organiques et leurs dérivés, les polymères d'amines, d'alcools ou de thiols organiques, les copolymères ou copolymères blocs d'un ou plusieurs acides organiques et d'une ou plusieurs polyamines, polyalcools ou polythiols organiques, les copolymères du styrène avec l'éthylène, les copolymères du styrène avec le propylène, les copolymères du styrène avec le butadiène, les copolymères du styrène avec les acrylates, les copolymères du styrène avec les méthacrylates et les combinaisons de deux ou plus de ceux-ci.

De préférence, ledit polymère est un copolymère bloc d'acide hydroxyoctadécanoïque et d'aziridine.

Dans un mode de réalisation préféré, le rapport en poids nanotubes / pigment / polymère est compris entre 1/1/1 et 1/5/1.

Avantageusement, le rapport en poids nanotubes / pigment / polymère est de 1/2/1.

Dans un second objet, l'invention décrit une dispersion stable de nanotubes de carbone utilisable dans le procédé de fabrication selon la présente invention comprenant les nanotubes décrits dans le premier objet uniformément répartis dans un solvant organique dans lequel ledit au moins un polymère est soluble.

Le solvant organique est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

De préférence, le solvant organique est le xylène.

Dans un mode de réalisation préféré de la dispersion, le pourcentage en poids de nanotubes est compris entre 0,01 et 5 % inclus par rapport au poids total de dispersion, le pourcentage en poids du pigment est compris entre 0,01 et 50 % inclus par rapport au poids total de la dispersion, et le rapport en poids du polymère est compris entre 0,01 et 5 % inclus par rapport au poids total de la dispersion.

Dans un troisième objet, l'invention décrit un dispositif pour vaporiser la dispersion de nanotubes utilisable dans le procédé de fabrication selon la présente invention qui est constitué d'un récipient muni d'un dispositif de vaporisation contenant la dispersion utilisable selon l'invention et un agent propulseur

Dans un quatrième objet, l'invention décrit un procédé de fabrication d'une dispersion de nanotubes de carbone utilisables selon l'invention, caractérisé en ce qu'il comprend les étapes suivantes :
a) ajout de nanotubes nus, d'au moins un polymère, et d'au moins un pigment, dans un solvant organique dans lequel le polymère est soluble,
b) mélange de la composition obtenue à l'étape a).

Dans un mode de réalisation préféré du procédé de fabrication d'une dispersion de nanotubes décrit dans le quatrième objet, l'étape a) comprend les étapes suivantes :
a₁) mélange des nanotubes et dudit au moins un pigment,
a₂) ajout d'un solvant organique dans lequel le polymère est soluble, au mélange obtenu à l'étape a₁), et
a₃) ajout du au moins un polymère au mélange obtenu à l'étape a₂).

Dans ce cas, de préférence, le mélange de l'étape a₁) s'effectue par broyage.

Dans tous les cas, de préférence, dans le procédé de fabrication d'une dispersion de nanotubes de carbone décrit dans le quatrième objet, le mélange de l'étape b) est effectué par sonication à la corne.

Dans une variante du procédé de fabrication d'une dispersion de nanotubes de carbone décrit dans le quatrième objet, une étape c) d'évaporation d'une partie du solvant est prévue, après l'étape b).

Dans tous les cas, le procédé de fabrication d'une dispersion de nanotubes de carbone décrit ci-dessus s'applique aux nanotubes mono-feuillets (SWNT), aux nanotubes double-feuillets (DWNT), aux nanotubes multi-feuillets (MWNT), aux nanotubes dont la croissance a été effectuée en phase vapeur (VGCF), aux nanofibres ou à toute structure carbonée cylindrique et à leurs mélanges.

De préférence, les nanotubes sont des nanotubes mono-feuillets, des nanotubes double-feuillets, des nanotubes multi-feuillets ou leurs mélanges.

Plus préférablement, les nanotubes sont des nanotubes mono-feuillets.

Selon une première caractéristique du procédé de fabrication d'une dispersion de nanotubes de carbone décrit ci-dessus, ledit au moins un pigment est choisi dans le groupe constitué par les pigments azo, les pigments monoazo jaune et orange, les pigments diazo, les pigments napthol, les pigments napthol AS (napthol rouge) les laques de pigment azo, les pigments benzimidazolone, les pigments de condensation diazo, les pigments complexes de métal, les pigments isoindolinone et isoindoline, les pigments polycycliques, les pigments phthalocyanine, une phthalocyanine de cuivre sulfonée contenant, en moyenne, 0,5 à 3 groupes d'acide sulfonique, une pthalocyanine de cuivre chlorée broyée, une phthalocyanine d'aluminium, une phthalocyanine bromée, une pthalocyanine d'hydroxyde d'aluminium, une pthalocyanine sans métal, les pigments quinophthalone, les pigments indathrone, les pigments diacrylide jaune, les pigments diazopyrozolione, les pigments azo-métal, les pigments triarylcarbonium, les pigments rhodamine laque, les pigments pérylène, les pigments quinacridone et les pigments dicétopyrrolopyrrole et les mélanges de deux ou plus de ceux-ci.

Dans ce cas, de préférence, ledit au moins un pigment est la phtalocyanine.

Selon une autre caractéristique du procédé de fabrication d'une dispersion de nanotubes de carbone tel que décrit ci-dessus, ledit polymère est choisi dans le groupe constitué par les polymères d'un ou plusieurs acides organiques ou acides hydroxyliques organiques et leurs dérivés, les polymères d'amines, d'alcools ou de thiols organiques, les copolymères ou copolymères blocs d'un ou plusieurs acides organiques et d'une ou plusieurs polyamines, polyalcools ou polythiols organiques, les copolymères du styrène avec l'éthylène, les copolymères du styrène avec le propylène, les copolymères du styrène avec le butadiène, les copolymères du styrène avec les acrylates, les copolymères du styrène avec les méthacrylates et les combinaisons de deux ou plus de ceux-ci.

De préférence, ledit polymère est un copolymère bloc d'acide hydroxyoctadécanoïque et d'aziridine.

Selon un mode de réalisation préféré du procédé de fabrication d'une dispersion de nanotubes de carbone **tel que décrit ci-dessus,** le rapport en poids nanotubes / pigment / polymère est compris entre 1/1/1 et 1/5/1.

Plus préférablement, le rapport en poids nanotubes / pigment / polymère est de 1/2/1.

Selon encore une autre caractéristique du procédé de fabrication d'une dispersion de nanotubes de carbone tel **que décrit ci-dessus,** le solvant organique est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylecétone, la diisopropylcétone, la méthylpropylcétone et les mélanges d'un ou plusieurs de ceux-ci.

De préférence, le solvant organique est le xylène.

De manière générale, dans le procédé de fabrication d'une dispersion de nanotubes de carbone **tel que décrit ci-dessus**, le pourcentage en poids de nanotubes est compris entre 0,01 et 5 % inclus par rapport au poids total de la dispersion, le pourcentage en poids du pigment est compris entre 0,01 et 50 % inclus par rapport au poids total de la dispersion, et le pourcentage en poids du polymère est compris entre 0,01 et 5 % inclus par rapport au poids total de la dispersion.

**Dans un** cinquième objet, l'invention **décrit** un procédé de fabrication d'une dispersion de nanotubes de carbone qui consiste à placer les nanotubes **décrits dans** le premier objet de l'invention sous forme de poudre dans un solvant organique dans lequel le polymère, ancré sur la couche de pigment recouvrant la périphérie externe des nanotubes, est soluble et à mélanger sous agitation le solvant et les nanotubes de l'invention.

Selon une caractéristique de ce procédé de fabrication d'une dispersion de nanotubes de carbone, le solvant organique est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

De préférence, le solvant organique est le xylène.

Toujours de préférence, **dans ce** cinquième objet, l'étape de mélange sous agitation du solvant organique et des nanotubes est effectuée par sonication à la corne.

**Dans un** sixième objet, l'invention **décrit** un procédé de fabrication de nanotubes de carbone **décrits dans** le premier objet, caractérisé en ce qu'il comprend les étapes du procédé de fabrication d'une dispersion **décrites dans** le quatrième ou le cinquième objet suivi d'une étape d) d'évaporation totale du solvant.

**Dans un** septième objet, l'invention **décrit** un matériau composite, **utilisable dans le cadre de la présente invention,** du type comprenant une matrice organique insoluble dans l'eau et des nanotubes de carbone, caractérisé en ce que les nanotubes de carbone sont des nanotubes **telles que décrites ci-dessus dans le premier objet.**

**Dans un** huitième objet, l'invention **décrit** l'utilisation des nanotubes **décrits dans** le premier objet de l'invention, ou obtenus par le procédé **décrit dans** le sixième objet pour la fabrication d'articles en matériau composite.

**Dans un** neuvième objet, l'invention **décrit** l'utilisation de la dispersion **décrite dans** le deuxième objet, ou obtenue par le procédé **décrit dans** le quatrième ou le cinquième objet pour la fabrication d'articles en matériau composite. Dans ces deux derniers objets, en particulier, l'article est un film ou une couche mince.

**Dans un** dixième objet, l'invention **décrit** l'utilisation du dispositif **décrit dans** le troisième objet pour la fabrication de films ou de couches minces.

**Dans un** onzième objet, l'invention **décrit** un procédé de fabrication d'un article en matériau composite du type comprenant une matrice polymérique insoluble dans, ou non miscible avec, l'eau et des nanotubes de carbone, caractérisé en ce qu'il comprend les étapes de fabrication d'une dispersion de nanotubes selon le procédé **décrit dans le** quatrième ou cinquième objet, suivies d'une étape e) de mise en solution du matériau constituant la matrice polymérique insoluble dans l'eau dans un solvant organique dans lequel le matériau constituant la matrice polymérique est soluble, d'une étape f) de mélange de la solution obtenue à l'étape e) avec la dispersion de nanotubes obtenus par le procédé **décrit dans** le quatrième ou cinquième objet, d'une étape g) de mise en forme de l'article voulu, et en ce que le solvant utilisé pour fabriquer la dispersion de nanotubes et le solvant utilisé pour dissoudre le matériau constituant la matrice polymérique sont solubles ou miscibles l'un dans l'autre.

De préférence, les deux solvants sont identiques.

Dans ce procédé, la matrice polymérique est choisie dans le groupe constitué par les polymères thermoplastiques, le polystyrène, le poly(méthacrylate de méthyle), le poly(chlorure de vinyle), le polyéthylène, le poly(téréphtalate d'éthylène), le poly(oxyde de méthylène), le polyacrylonitrile, les polyesters, les polyuréthanes, les polyamides, les mélanges et copolymères de deux ou plus de ceux-ci.

De préférence, la matrice polymérique est un polyamide

**La description des objets** sera mieux comprise et d'autres avantages et caractéristiques de **ceux-ci** apparaîtront plus clairement à la lecture de la description explicative qui suit qui est faite en référence aux figures annexées dans lesquelles :
- la figure 1 représente une vue en perspective partiellement arrachée d'un nanotube tel **que décrit ci-dessus et utilisable dans le cadre de la présente invention**,
- la figure 2 représente une photographie au microscope optique à un grossissement de 60 d'une dispersion **telle que décrit ci-dessus et utilisable dans le cadre de la présente invention** notée XFF09 dans la description qui suit,
- la figure 3 représente une photographie au microscope optique à un grossissement de 60 d'une autre dispersion **telle que décrit ci-dessus et utilisable dans le cadre de la présente invention** notée XFF05 dans la description qui suit, et
- la figure 4 représente une photographie au microscope optique un grossissement de 60 d'une dispersion ne tombant pas dans le cadre **du second objet décrit ci-dessus** notée XFF010 dans la description qui suit.

Dans la description, les revendications et les figures qui suivent, la référence numérique 1 désigne des nanotubes de carbone "nus" comme défini ci-dessus, la référence numérique 2 désigne la périphérie externe de ces nanotubes 1 en contact, soit avec l'air, soit avec le(s) solvant(s), ou la matrice polymérique, avant leur traitement selon l'invention et la référence numérique 7 désigne les nanotubes de carbone "complexés" selon l'invention.

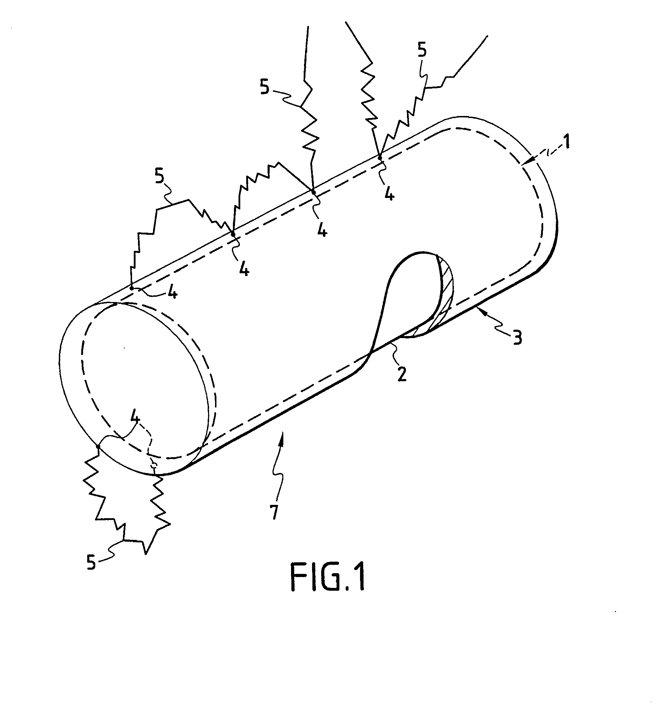

Les nanotubes de carbone "complexés" **utilisables** selon l'invention seront d'abord décrits en référence à la figure 1.

Comme on le voit en figure 1, le nanotube de carbone "nu" tel qu'il peut être acheté dans le commerce et non traité selon l'invention est noté 1 et le nanotube selon l'invention est noté 7.

Le nanotube 7 est donc constitué du nanotube "nu" 1 que l'on a recouvert d'une couche d'au moins un pigment 3. La couche de pigment 3 est adsorbée sur la surface périphérique externe notée 2 du nanotube 1.

La couche de pigment 3 recouvre uniquement la surface externe des nanotubes.

En effet, les nanotubes sont constitués d'une feuille de graphite enroulée sur elle-même. Cependant, ce tube est "bouché" aux extrémités par deux demi-sphères ce qui rend l'intérieur du nanotube inaccessible pour le(s) pigment(s) et pour le(s) polymère(s). Le pigment 3 s'adsorbe donc uniquement sur la périphérie externe des nanotubes puisque c'est la seule surface qui peut être en contact avec le pigment 3.

De plus, le nanotube 7 **utilisable** selon l'invention comporte au moins un polymère 5 lié à la couche de pigment 3 par au moins un point d'ancrage noté 4.

Comme on peut le voir en figure 1, le polymère 5 peut avoir un seul point d'ancrage 4 sur la couche de pigment 3 ou peut en avoir plusieurs, le reste de la chaîne du polymère 5 flottant librement et recouvrant et protégeant la totalité du nanotube par encombrement stérique.

Le pigment 3 est lié aux nanotubes de carbone et le polymère 5 est lié à la couche de pigment 3, par des interactions de type Van der **Waals.**

C'est pourquoi on entend ici, par "complexation" une interaction sans liaison chimique.

Le polymère 5 peut être un homopolymère ou un copolymère linéaire ou ramifié, de préférence un copolymère bloc.

Des exemples de polymère 5 d'un ou plusieurs acides organiques ou acides hydroxyliques organiques et leurs dérivés. En particulier, il pourra s'agir des polymères d'amines, d'alcools ou de thiols organiques, des copolymères ou copolymères blocs d'un ou plusieurs acides organiques avec une ou plusieurs polyamines, polyalcools ou polythiols organiques, des copolymères du styrène avec l'éthylène, des copolymères du styrène avec le propylène, des copolymères du styrène avec le butadiène, des copolymères du styrène avec les acrylates, des copolymères du styrène avec les méthacrylates et des combinaisons de deux ou plus de ceux-ci.

De préférence, ledit polymère est un copolymère bloc d'acide hydroxyoctadécanoïque et d'aziridine.

Selon la surface spécifique des nanotubes de carbone "nu" 1, le rapport en poids nanotubes 1 / pigment 3 / polymère 5 pourra varier. Il est de préférence compris entre 1/1/1 et 1/5/1, et encore plus préférablement de 1/2/1.

Les nanotubes **utilisables dans le cadre** de l'invention tels que décrits ci-dessus sont sous forme de poudre et peuvent donc être facilement stockés, transportés et manipulés.

Cependant, pour les utiliser en tant que charge dans une matrice polymérique, il faut, comme on l'a vu précédemment préparer une dispersion stable et à répartition uniforme en nanotubes de carbone.

On rappellera ici, que l'on considère qu'une dispersion est stable lorsqu'il n'y a pas de dépôt au fond du récipient au bout de 4 jours voire plusieurs mois.

Ce dépôt, dans le cadre d'une dispersion non stable, est dû à l'agrégation des particules mises en suspension lors des différents traitements qu'elles ont subis lors de la fabrication de la dispersion, en particulier lors du traitement aux ultrasons.

Par répartition uniforme des nanotubes de carbone, on entend que la répartition des nanotubes de carbone est homogène dans l'ensemble de la dispersion, c'est-à-dire que les nanotubes de carbone sont répartis de façon homogène en tout point de la dispersion.

Ainsi, un critère qui permet d'affiner la notion de "répartition uniforme" des nanotubes de carbone dans la dispersion est la taille des agrégats. Plus ces agrégats sont petits, plus la dispersion est uniforme car il y a moins d'agglomération de nanotubes.

Cependant, une dispersion peut être stable et à répartition uniforme en nanotubes de carbone mais avec uniformité de gros agrégats. Ceci n'est pas le cas préféré, mais accepté dans le cadre de **la présente description**.

Le cas parfait est une dispersion stable et uniforme avec une répartition homogène dans la dispersion de tous petits agrégats ou pas d'agrégats du tout, auquel cas les nanotubes sont parfaitement individualisés.

Ainsi, par répartition uniforme, on entend une répartition homogène au sein de la dispersion d'agrégats de nanotubes, ces agrégats ne devant pas dépasser une taille limite correspondant à une répartition certes uniforme mais pas homogène.

Ainsi, la taille des agrégats est un critère mais ce critère est à nuancer en fonction de la concentration en nanotubes de la dispersion.

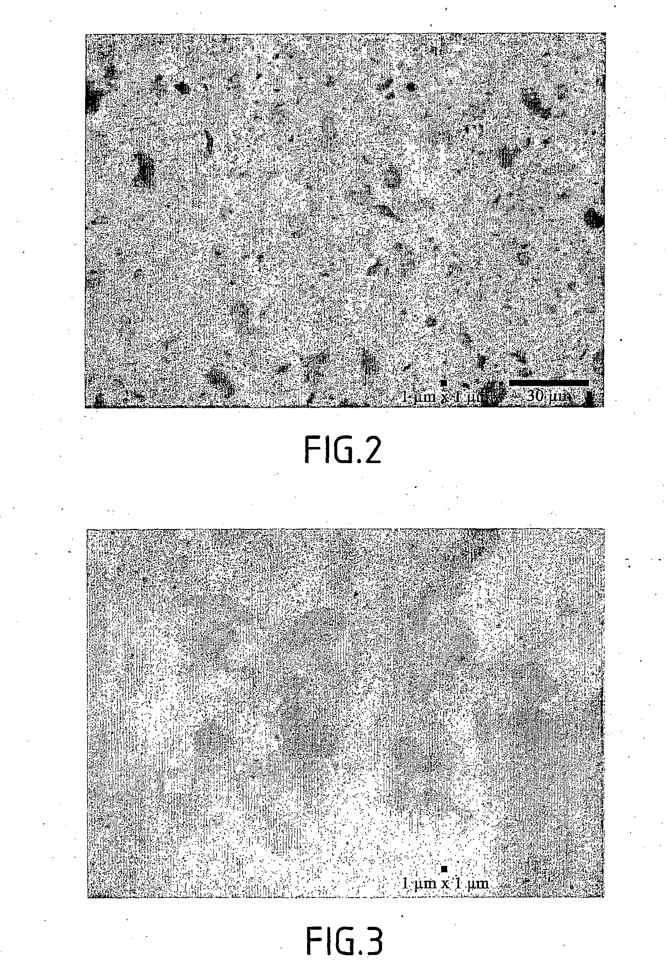

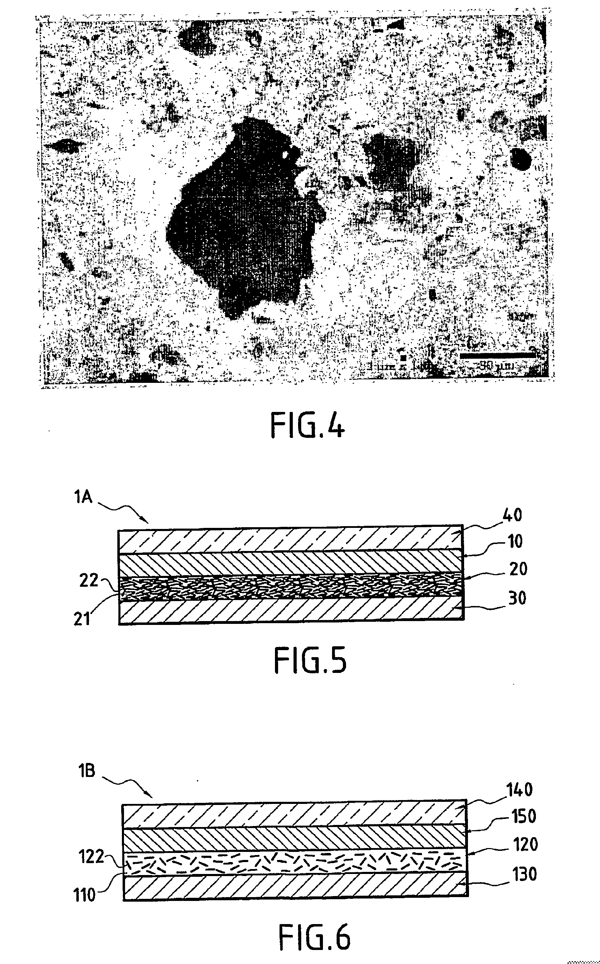

Ainsi, en comparant les figures 2, 3 et 4, on constate sur la figure 2, qu'on a une dispersion à répartition uniforme en nanotubes de carbone avec de très petits agrégats, et sur la figure 3, qu'on a également une dispersion à répartition uniforme en nanotubes avec des agrégats plus gros, et sur la figure 4, qu'on a une dispersion qui n'est pas à répartition uniforme en nanotubes, ces nanotubes étant regroupés en gros agrégats, ce qui fait qu'ils ne sont pas répartis de façon homogène dans toute la dispersion.

Les nanotubes 7 **utilisables dans le cadre** de l'invention peuvent être redispersés dans un solvant organique 6 dans lequel le polymère 5 est soluble, et ce de manière stable, avec une répartition uniforme. Dans ces dispersions, la concentration en poids en nanotubes 7 peut varier entre 0,01 % à 5 % inclus, typiquement de 0,2 % à 5 % en poids, le reste étant le solvant organique.

Le solvant organique 6 est un milieu liquide organique. Il peut s'agir d'un solvant organique polaire ou, plus préférablement d'un solvant organique apolaire. Le terme "apolaire" désigne un liquide organique ou une résine possédant une constante diélectrique ε typiquement inférieur à 9,5.

Des exemples de solvant organique 6 sont les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

Cette redispersion des nanotubes se fait par simple mélange des nanotubes dans le solvant 6 choisi dans lequel le polymère 5 est soluble, à température ambiante.

La dispersion obtenue est stable pendant plusieurs mois et les nanotubes 7 complexés sont répartis uniformément dans cette dispersion, comme on peut le voir en figure 2.

Cependant, une telle dispersion de nanotubes dans le solvant organique 6 défini ci-dessus peut aussi être obtenue directement.

Ainsi, un procédé pour obtenir une dispersion stable de nanotubes de carbone dans le solvant organique 6 comprend les étapes suivantes :
a) ajout de nanotubes 1, d'au moins un polymère 5, d'au moins un pigment 3, dans un solvant organique 6 dans lequel le polymère 5 est soluble,
b) mélange de la composition obtenue à l'étape a).

Dans un mode de réalisation préféré, l'étape a) comprend les étapes suivantes :
a₁) mélange des nanotubes et dudit au moins un pigment 3,
a₂) ajout d'un solvant organique 6 dans lequel le polymère 5 est soluble, au mélange obtenu à l'étape a₁), et
a₃) ajout du au moins un polymère 5, au mélange obtenu à l'étape a₂).

De préférence, le mélange de l'étape b) est effectué par sonication à la corne.

Pour augmenter la concentration en nanotubes de cette dispersion, ce procédé comprend de plus, après l'étape b), une étape c) d'évaporation d'une partie du solvant 6.

Dans ce procédé, les nanotubes 1, 7, le solvant organique 6, le polymère 5 et le pigment 3, entrant dans la composition de ces dispersions, sont les mêmes que ceux précédemment décrits.

De même les proportions et les concentrations en poids de nanotubes de carbone 1, 7, de pigment 3, de polymère 5 et solvant organique 6 sont identiques à celles décrites précédemment.

A partir de cette dispersion, on peut obtenir les nanotubes **utilisables dans le cadre** de l'invention sous forme de poudre, en procédant, après l'étape b) à une évaporation totale du solvant.

Les dispersions **décrites ci-dessus** pourront être utilisées telles quelles pour fabriquer un matériau composite ou un article en matériau composite.

Dans un mode de réalisation particulièrement avantageux, les dispersions seront placées dans un récipient comprenant un dispositif de vaporisation et un agent propulseur, tel qu'un gaz, éventuellement un gaz liquéfié. Un tel dispositif sera particulièrement avantageux pour réaliser des films ou des couches minces de nanotubes de carbone.

Dans ce cas, on pourra ajouter à la dispersion de nanotubes de carbone **décrites ci-dessus**, un agent filmogène ou un liant, telle qu'une résine ou un agent tensioactif.

On observe également au bout de quatre jours et au bout de plusieurs mois, la taille des agrégats de nanotubes de carbone.

Les nanotubes **utilisables dans le cadre de** l'invention ainsi que les dispersions **décrites ci-dessus** pourront être utilisés très simplement pour la fabrication de matériaux composite ou d'articles en matériau composite.

Par article en matériau composite, on entend également les films et les couches minces qui pourront également être fabriqués même sans utiliser le dispositif de vaporisation **décrit ci-dessus**.

Un procédé typique de fabrication d'un matériau composite ou d'un article en matériau composite du type comprenant une matrice polymérique insoluble dans l'eau et des nanotubes de carbone comprend les étapes des procédés de fabrication d'une dispersion de nanotubes **décrits ci-dessus**, suivies de
- une étape e) de mise en solution du matériau constituant la matrice polymérique insoluble dans l'eau dans un solvant organique 7 dans lequel le matériau constituant la matrice polymérique est soluble,
- une étape f) de mélange de la solution obtenue à l'étape e) avec la dispersion de nanotubes obtenue par le procédé **décrit ci-dessus**, et
- une étape g) de mise en forme de l'article voulu, et le solvant 6 utilisé pour fabriquer la dispersion de nanotubes,

le solvant 7 utilisé pour dissoudre le matériau constituant la matrice polymérique étant solubles l'un dans l'autre.

De préférence, le solvant 6 et le solvant 7 sont identiques.

La matrice polymérique dans laquelle les nanotubes 7 sont ajoutés peut être en tout matériau polymérique insoluble dans l'eau tels que les polymères thermoplastiques, le polystyrène, le poly(méthacrylate de méthyle), le poly(chlorure de vinyle), le polyéthylène, le poly(téréphtalate d'éthylène), le poly(oxyde de méthylène), le polyacrylonitrile, les polyesters, les polyuréthanes, les polyamides, les mélanges et copolymères de deux ou plus de ceux-ci.

Afin de mieux faire comprendre **la présente description,** on va décrire maintenant plusieurs modes de réalisation **des objets indiqués ci-dessus** qui ne sont donnés qu'à titre purement illustratifs et non limitatifs.

Tout d'abord, on a fabriqué 17 dispersions de nanotubes de carbone à différentes concentrations en poids en nanotubes 1, en pigment 3, en polymère 5. On a maintenu la quantité de solvant constante, à part pour l'échantillon XF002.

On a ensuite testé les 17 dispersions obtenues quant à la stabilité et à la répartition uniforme des nanotubes de carbone, comme décrit précédemment.

Les nanotubes de carbone utilisés étaient des nanotubes de carbone "nus" fabriqués et commercialisés par la société NANOLEDGE S.A., Montpellier, France.

Le pigment utilisé était un mélange de pigments à base de phtalocyanine commercialisé par la société AVECIA S.A./N.V., Bruxelles, Belgique sous la marque enregistrée Solsperse RTM 5000^{®}.

Le polymère était un copolymère bloc d'acide hydroxyoctadécanoïque et d'aziridine commercialisé par la société AVECIA S.A./N.V., Bruxelles, Belgique sous la marque enregistrée Solsperse RTM 24000SC^{®}. Le solvant était le xylène (mélange d'isomères, puriss.p.a.) commercialisé par SIGMA-ALDRICH CHIMIE S.A.R.L., 38299 Saint Quentin Fallavier Cedex.

On a ensuite observé chacune de ces 17 dispersions au microscope optique, à un grossissement de 60, pour évaluer la présence éventuelle d'agrégats de nanotubes et s'il y avait des agrégats de nanotubes, évaluer la taille de ces agrégats. Cette mesure est représentative de la répartition, uniforme ou non des nanotubes de carbone dans la dispersion.

Dans les tableaux, la taille des agrégats est notée de 1 à 5 :
- la notation 5 correspond à une taille d'agrégats supérieure à 100 000 nm.
- la notation 4 pour la taille des agrégats désigne des agrégats d'une taille inférieure à 100 000 nm mais supérieure à 10 000 nm,
- la notation 3 désigne des agrégats d'une taille inférieure à 10 000 nm mais supérieure à 1 000 nm,
- la notation 2 désigne des agrégats d'une taille inférieure ou égale à 1 000 nm, et
- la notation 1 désigne des agrégats d'une taille inférieure à 1 000 nm, plus préférablement égale à 250 nm.

On l'a vu, plus la taille des agrégats est faible, plus la répartition des nanotubes de carbone dans la dispersion est uniforme.

Puis on a stocké chacune des ces dispersions à température ambiante pendant quatre jours et quatre mois et on les a examinées à nouveau au bout de chacune de ces périodes pour déterminer s'il y avait une précipitation et/ou une réagglomération des nanotubes de carbone

### Exemple comparatif 1 : noté XF001 dans le tableau 1

Dans ce cas, et à titre de comparaison, on a fabriqué une dispersion de nanotubes de carbone sans utilisation de polymère.

On a mélangé par broyage à sec dans un broyeur à bille 10,0 mg de nanotubes "nus" (1) avec 20,0 mg de pigment.

Le rapport en poids de nanotubes 1 / pigment 3/ polymère 5 est ainsi de 1/2/0 dans cet exemple.

Ensuite, on a ajouté à ce mélange 5000,3 mg de xylène et l'on a mélangé en soniquant au bain 2 fois pendant 15 minutes.

### Exemple comparatif 2 : noté XF002 dans le tableau 1

Cette dispersion a également été fabriquée à titre de comparaison.

Dans cet exemple, la dispersion de nanotubes de carbone a été fabriquée sans utiliser de pigment. Ainsi, on a mélangé par broyage à sec dans un broyeur à bille 6,8 mg de nanotubes de carbone nus avec 3,7 mg de polymère. Le rapport en poids nanotubes / pigment / polymère est de 1/0/0,54.

On ajoute à ce mélange 2503,0 mg de solvant et l'on mélange l'ensemble en soniquant au bain 2 fois pendant 15 minutes.

Les résultats de mesure de taille des agrégats et de stabilité sont reportés au tableau 1.

### Exemple comparatif 3 : noté XF010 dans le tableau 1

On mélange par broyage à sec dans un broyeur à bille 10,1 mg de nanotubes nus et 8,4 mg de polymère. Ici, il n'y avait pas de pigment.

Le rapport en poids nanotubes / pigment / polymère est de 1/0/0,83 dans cet exemple.

On ajoute au mélange broyé obtenu 4951,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 1 : noté XF003 dans le tableau 1

On a mélangé par broyage à sec dans un broyeur à bille 9,5 mg de nanotubes de carbone nus, 12,3 mg de pigment et 4,0 mg de polymère soit un rapport en poids nanotubes / pigment / polymère de 1/0,3/0,42.

On ajoute à ce mélange 5000,13 mg de xylène et on mélange en soniquant au bain 2 fois pendant 15 minutes.

Les résultats de l'évaluation de la stabilité et de la répartition uniforme de la dispersion obtenue sont reportés au tableau 1.

### Exemple 2 : noté XF004 dans le tableau 1

On a mélangé 9,8 mg de nanotubes de carbone nus avec 20,3 mg de pigment et 6,1 mg de polymère par broyage à sec dans un broyeur à bille.

Le rapport en poids nanotubes / pigment / polymère est de 1/2,07/0,62.

On ajoute à ce mélange 5000,0 mg de xylène et on mélange en soniquant au bain 2 fois pendant 15 minutes.

Les résultats de l'évaluation de la stabilité et de la répartition uniforme de la dispersion obtenue sont reportés au tableau 1.

### Exemple 3 : noté XF005 dans le tableau 1

On a mélangé 9,9 mg de nanotubes de carbone nus avec 1,0 mg de pigment et 6,8 mg de polymère par broyage à sec dans un broyeur à bille.

Le rapport en poids nanotubes / pigment / polymère est de 1/0,1/0,69.

On ajoute à ce mélange 5035,0 mg de xylène et on mélange en soniquant au bain 2 fois pendant 15 minutes.

Les résultats de l'évaluation de la stabilité et de la répartition uniforme de la dispersion obtenue sont reportés au tableau 1.

### Exemple 4 : noté XF006

On mélange par broyage à sec dans un broyeur à bille 10,4 mg de nanotubes de carbone nus, 32,6 mg de pigment et 8,3 mg de polymère.

Le rapport en poids nanotubes / pigment / polymère est de 1/3,1/0,80 dans cet exemple.

On ajoute au mélange broyé obtenu 5008,0 mg de xylène en soniquant au bain 2 fois pendant 15 minutes.

Les résultats de l'évaluation de la stabilité et de la répartition uniforme des nanotubes dans cette dispersion sont reportés au tableau 1.

### Exemple 5 : noté XF007 dans le tableau 1

On mélange par broyage à sec dans un broyeur à bille 10,3 mg de nanotubes nus, 2,7 mg de pigment et 8,0 mg de polymère.

Le rapport en poids nanotubes / pigment / polymère est de 1/0,26/0,78 dans cet exemple.

On ajoute au mélange broyé obtenu 5008,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 6 : noté XF008 dans le tableau 1

On mélange par broyage à sec dans un broyeur à bille 10,2 mg de nanotubes nus, 3,9 mg de pigment et 8,2 mg de polymère.

Le rapport en poids nanotubes / pigment / polymère est de 1/0,38/0,80 dans cet exemple.

On ajoute au mélange broyé obtenu 5000,2 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 7 : noté XF009 dans le tableau 1

On mélange par broyage à sec dans un broyeur à bille 10,1 mg de nanotubes nus, 10,0 mg de pigment et 8,4 mg de polymère.

Le rapport en poids nanotubes / pigment / polymère est de 1/1/0,83 dans cet exemple.

On ajoute au mélange broyé obtenu 5010,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 8 : noté XF011 dans le tableau 1

On mélange par broyage à sec dans un broyeur à bille 10,3 mg de nanotubes nus, 1,6 mg de pigment et 8,5 mg de polymère.

Le rapport en poids nanotubes / pigment / polymère est de 1/0,15/0,82 dans cet exemple.

On ajoute au mélange broyé obtenu 4991,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 9 : noté XF012 dans le tableau 1

On mélange par broyage à sec dans un broyeur à bille 9,8 mg de nanotubes nus, 30,5 mg de pigment et 10,2 mg de polymère.

Le rapport en poids nanotubes / pigment / polymère est de 1/3,1/1,04 dans cet exemple.

On ajoute au mélange broyé obtenu 5006,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 10 : noté XF013 dans le tableau 1

On mélange par broyage à sec dans un broyeur à bille 10,3 mg de nanotubes nus, 11,2 mg de pigment et 10,3 mg de polymère.

Le rapport en poids nanotubes / pigment / polymère est de 1/0,1/1 dans cet exemple.

On ajoute au mélange broyé obtenu 5004,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 11 : noté XF014 dans le tableau 1

On mélange par broyage à sec dans un broyeur à bille 9,7 mg de nanotubes nus, 22,7 mg de pigment et 10,5 mg de polymère.

Le rapport en poids nanotubes / pigment / polymère est de 1/2,34/1,08 dans cet exemple.

On ajoute au mélange broyé obtenu 4994,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 12 : noté XF015 dans le tableau 1

On mélange par broyage à sec dans un broyeur à bille 10,3 mg de nanotubes nus, 20,2 mg de pigment et 15,3 mg de polymère.

Le rapport en poids nanotubes / pigment / polymère est de 1/1,96/1,48 dans cet exemple.

On ajoute au mélange broyé obtenu 4994,0 mg de xylène on mélange en soniquant au bain 2 fois pendant 15 minutes.

Les résultats de l'évaluation de la stabilité et de la répartition uniforme des nanotubes dans cette dispersion sont reportés au tableau 1.

### Exemple 13 : noté XF016 dans le tableau 1

On mélange par broyage à sec dans un broyeur à bille 10,3 mg de nanotubes nus, 47,5 mg de pigment et 16,4 mg de polymère.

Le rapport en poids nanotubes / pigment / polymère est de 1/4,61/1,59 dans cet exemple.

On ajoute au mélange broyé obtenu 4995,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 14 : noté XF017 dans le tableau 1

On mélange par broyage à sec dans un broyeur à bille 10,1 mg de nanotubes nus, 20,6 mg de pigment et 33,2 mg de polymère.

Le rapport en poids nanotubes / pigment / polymère est de 1/2/3,3 dans cet exemple.

On ajoute au mélange broyé obtenu 5003,0 mg de xylène et on mélange en soniquant au bain 2 fois pendant 15 minutes.

Les résultats de l'évaluation de la stabilité de la répartition uniforme des nanotubes dans cette dispersion sont reportés au tableau 1.

**TABLEAU 1**

| Dispersion | **Poids de nanotubes en mg** | **Poids de pigment en mg** | **Poids de polymère en mg** | **Rapport en poids nanofibres/pigment/polymère** | **Poids de xylène en mg** | **agrégats** |
|---|---|---|---|---|---|---|
| **XF001** | 10,0 | 20,0 | 0 | 1/2/0 | 5000,3 | 5 |
| **XF002** | 6,8 | 0,0 | 3,7 | 1/0/0,5 | 2503,0 | 5 |
| **XF010** | 10,1 | 0,0 | 8,4 | 1/0/0,8 | 4951,0 | 5 |
| **XF003** | 9,5 | 12,3 | 4,0 | 1/1,3/0,4 | 5013,0 | 3 |
| **XF004** | 9,8 | 20,3 | 6,1 | 1/2,1/0,6 | 5000,0 | 3 |
| **XF005** | 9,9 | 1,0 | 6,8 | 1/0,1/0,7 | 5035,0 | 3 |
| **XF006** | 10,4 | 32,6 | 8,3 | 1/3,1/0,8 | 5000,0 | 4 |
| **XF007** | 10,3 | 2,7 | 8,0 | 1/0,26/0,8 | 5008,0 | 3 |
| **XF008** | 10,2 | 3,9 | 8,2 | 1/0,38/0,8 | 5002,0 | 3 |
| **XF009** | 10,1 | 10,0 | 8,4 | 1/1/0,8 | 5010,0 | 3 |
| **XF011** | 10,3 | 1,6 | 8,5 | 1/0,15/0,8 | 4991,0 | 3 |
| **XF012** | 9,8 | 30,5 | 10,2 | 1/3,1/1 | 5006,0 | 2 |
| **XF013** | 10,1 | 11,2 | 10,3 | 1/0,1/1 | 5004,0 | 3 |
| **XF014** | 9,7 | 22,7 | 10,5 | 1/2,34/1,1 | 4994,0 | 1 |
| **XF015** | 10,3 | 20,2 | 15,3 | 1/1,96/1,5 | 4994,0 | 3 |
| **XF016** | 10,3 | 47,5 | 16,4 | 1/4,61/1,6 | 4995,0 | 2 |
| **XF017** | 10,1 | 20,6 | 33,2 | 1/2/2,3 | 5003,0 | 3 |

Toutes les dispersions obtenues en utilisant le pigment et le polymère étaient stables c'est-à-dire ne présentaient ni précipitation ni réagglomération des nanotubes au bout de 4 jours de stockage à température ambiante alors que les dispersions obtenues en utilisant soit le polymère soit le pigment tout seul n'étaient stables que pendant quelques minutes.

Toutes les dispersions stables au bout de 4 jours de stockage à température ambiante l'étaient également au bout de 4 mois. Elles étaient mêmes meilleures, car on a noté dans ce cas une diminution de la taille des agrégats de nanotubes de carbone tout en conservant une répartition uniforme et homogène et sans dépôt au fond du récipient de stockage.

On voit à partir du tableau 1 que les dispersions obtenues sans pigment et sans polymère présentent toutes une taille d'agrégats de 5, ce qui montre qu'elles n'étaient pas à répartition uniforme.

Ainsi, la dispersion sera considérée comme étant à répartition uniforme lorsque la notation attribuée pour taille des agrégats est de 2 ou 1.

On voit à partir du tableau 1 que les dispersions obtenues à l'exemple 10 (noté XF012 dans le tableau 1) à l'exemple 12 (noté XF014 dans le tableau 1) et à l'exemple 14 (noté XF016 dans le tableau 1) permettent d'obtenir une dispersion stable et à répartition uniforme des nanotubes de carbone.

Ainsi, bien que ce rapport puisse varier en fonction de la surface spécifique des nanotubes de carbone nus utilisés pour fabriquer les nanotubes de carbone **utilisables dans le cadre de** l'invention et les dispersions de nanotubes de carbone nus utilisés pour fabriquer les nanotubes de carbone **utilisables dans le cadre** de l'invention et les dispersions de nanotubes de carbone **décrites ci-dessus,** les rapports préférés en poids nanotubes / pigment / polymère sont compris entre 1/5/1 et 1/2/1 avec les meilleurs résultats étant obtenus avec un rapport en poids nanotubes / pigment / polymère de 1/2/1.

Les essais suivants ont visé à trouver la meilleure méthode de fabrication des dispersions et des nanotubes **utilisables dans le cadre de** l'invention.

Pour ces essais, on a maintenu le rapport en poids nanotubes / pigment / polymère constant c'est-à-dire à un rapport de 1/2/1.

On a fait varier la quantité de solvant, de pigment ainsi que la méthode de mélange du pigment aux nanotubes de carbone et au polymère, dans le solvant.

Quatorze nouvelles dispersions ayant toutes un rapport en poids nanotubes / pigment / polymère de 1/2/1 ont été préparées.

Les nanotubes nus, le pigment, le polymère et le solvant utilisés pour réaliser ces dispersions sont les mêmes que ceux utilisés pour la fabrication des dispersions XF001 à XF017 décrites ci-dessus.

Les différents poids de nanotubes, de pigment et de polymère ainsi que de solvant, en mg, sont reportés au tableau 2 ci-après.

La concentration finale, en poids, de nanotubes dans la dispersion obtenue est également reportée au tableau 2 ainsi que les résultats de l'évaluation de la stabilité et de la répartition uniforme des nanotubes dans la dispersion.

Les conditions opératoires pour fabriquer ces dispersions sont indiquées au tableau 3.

Dans le tableau 3 :
- BM indique que le mélange nanotubes / pigment / polymère, qu'il soit effectué en une seule étape a) ou en trois étapes notées a₁) a₂) et a₃) dans la description qui précède, a été effectué par broyage à la main dans un mortier en porcelaine, et que le broyage de ces poudres a eu lieu en rajoutant quelques gouttes de solvant.
- BBS indique que le mélange nanotubes / pigment / polymère ou nanotubes / pigment a été effectué par broyage à sec, sans solvant, dans un vibro-broyeur automatique Retsch MM 2000 Bioblock Scientific, Illkirch, France, puissance 600 Watt, fréquence 20 kHz dans lequel était placé une seule bille en acier, en réutilisant un réglage de l'amplitude de 70 et pendant la durée spécifiée au tableau 3.
- BBH indique que le mélange nanotubes / pigment / polymère ou nanotubes / pigment a été effectué dans le même broyeur que précédemment, dans les mêmes conditions, sauf que les poudres de départ sont mouillées avec quelques gouttes de solvant.

Le mélange nanotubes-pigment ou nanotubes-pigment-polymère est ensuite additionné de la totalité du solvant et mélangé pendant la durée indiquée au tableau 3. Ce mélange est effectué soit par une sonication au bain notée SB, soit par une sonication à la corne notée SC au tableau 3.

La sonication au bain correspond au traitement par ultrasons de la dispersion, les ultrasons étant générés dans un bain DELTASONIC P500 S/R. La dispersion est contenue dans un récipient et plongée dans un bain d'eau distillée, les ultrasons sont transmis à l'échantillon au travers du bain. La durée du traitement est spécifiée au tableau 3.

Le traitement de sonication à la corne correspond à un traitement de la dispersion avec des ultrasons générés par une corne. L'appareillage utilisé est un appareil BIOBLOCK SCIENTIFIC VIBRACELL 75455 avec une impulsion de valeur 4 et une amplitude de valeur 60. La dispersion est contenue dans un récipient en verre qui est plongé dans un bain d'eau distillée. La fonction du bain est exclusivement de refroidir l'échantillon pendant l'application des ultrasons et non de transmettre l'énergie. En fait, la corne génératrice des ultrasons est plongée directement dans la dispersion et les ultrasons sont appliqués directement.

Dans certains cas, une étape d'évaporation partielle du solvant a été effectuée pour concentrer la dispersion. Pour ce faire, la dispersion est placée dans un récipient en verre résistant à la chaleur et réchauffé à l'aide d'une plaque chauffante munie d'un mélangeur magnétique. Le chauffage est maintenu pendant le temps spécifié au tableau 3, en même temps, tout en agitant l'échantillon. La durée de l'agitation notée A au tableau 3 est indiquée au tableau 3.

Pour optimiser ces conditions, on a de plus effectué l'essai suivant :

### EXEMPLE 15 : Echantillon XFF013

On mélange par broyage en milieu humide dans un broyeur à billes : 25,2 mg de nanotubes nus, 50,8 mg de pigment et 524,3 mg de xylène.

On ajoute au mélange broyé obtenu 4483,1 mg de xylène et on applique un traitement de sonication à la corne pendant 30 minutes au mélange obtenu.

On ajoute ensuite 25,8 mg de polymère.

Le rapport en poids nanotubes / pigment / polymère est de 1/2/1.

On évapore ensuite 4605,2 mg de xylène. La dispersion ainsi obtenue a une concentration en % en poids de nanotubes, par rapport au poids total de la dispersion de 5 % et reste stable pendant plusieurs mois.

**TABLEAU 2**

| Echantillon | **Poids de nanotubes en mg** | **Poids de pigment en mg** | Poids de | **Poids de xylène en mg** | **Concentration finale en % en poids de nanotubes** | Agrégats |
|---|---|---|---|---|---|---|
| | | | **polymère en mg** | | | |
| **XFF001** | 10,01 | 23,00 | 10,90 | 5000 | 0,2 | 4 |
| **XFF002** | 100,00 | 230,00 | 100,00 | 5000 | 1,9 | 4 |
| **XFF003** | 50,70 | 104,00 | 59,00 | 5000 | 1,0 | 4 |
| **XFF004** | 100,70 | 202,00 | 100,00 | 5000 | 1,9 | 4 |
| **XFF005** | 50,10 | 115,00 | 55,00 | 5000 | 1,0 | 3 |
| **XFF006** | 52,00 | 102,00 | 50,00 | 5000 | 1,0 | 3 |
| **XFF007** | 25,00 | 54,00 | 25,00 | 5000 | 0,5 | 2 |
| **XFF008** | 300,00 | 600,00 | 300,00 | 15000 | 1,9 | 3 |
| **XFF009** | 66,00 | 136,00 | 69,00 | 3300 | 1,8 | 2 |
| **XPF010** | 200,00 | 400,00 | 202,00 | 10000 | 1,9 | 5 |
| **XFF011** | 150,00 | 300,00 | 165,00 | 7500 | 1,9 | 3 |
| **XFF012 a** | 200,85 | 403,04 | 198,36 | 38970 | 0,5 | 2 |
| **XFF012 b** | 401,71 | 806,09 | 396,71 | 38970 | 1,0 | 3 |
| **XFF012 c** | 803,43 | 612,17 | 793,43 | 38970 | 2,0 | 3 |
| **XFF013** | 25,2 | 50,5 | 25,8 | 402 | 5,0 | 3 |

**TABLEAU 3**

| | BM | **BBS** | BBH | SB | SC | E | A |
|---|---|---|---|---|---|---|---|
| **XFF001** | 2 min | | | 30 min | | | |
| **XFF002** | 2 min | | | 30 min | | | |
| **XFF003** | 2 min | | | | | | 750 min |
| **XFF004** | 2 min | | | | | | 750 min |
| **XFF005** | 2 min | | | | 30 min | X | |
| **XFF006** | 2 min | | | | | X | |
| **XFF007** | | | | | 60 min | X | |
| **XFF008** | 2 min | | | | 60 min | | |
| **XFF009** | | 3 min | | | 30 min | X | 840 min |
| **XFF010** | | | 3 min | | 30 min | X | |
| **XFF011** | | | 5 min | | 60 min | X | |
| **XFF012 a** | | | 3 min | | 75 min | | |
| **XFF012 b** | | | 3 min | | 75 min | X | |
| **XFF012 c** | | | 3 min | | 75 min | X | |
| **XFF013** | | | 3 min | | 30 min | X | |

Les résultats de l'évaluation de la stabilité et de la répartition uniforme des nanotubes dans les dispersions obtenues montrent que seules les dispersions XFF009, XFF007 et XFF005 sont des dispersions non seulement stables mais également à répartition uniforme en nanotubes de carbone, comme on peut le voir en comparant les figures 2, 3 et 4 qui montrent des photographies prises au microscope optique à un grossissement de 60 de la dispersion XFF005 (figure 2) et la dispersion XFF009 (figure 3) et de la dispersion XFF010 (figure 4).

On voit que la taille des agrégats dans la dispersion XFF005 et XFF009 sont nettement plus faibles que la taille des agrégats dans la dispersion XFF010, ce qui dénote une répartition uniforme des nanotubes de carbone dans les dispersions XFF005 et XFF009 contrairement à la dispersion XFF010. C'est pour cette raison que l'on considère qu'un traitement aux ultrasons à la corne en combinaison avec un broyage dans un broyeur à bille, de préférence en milieu humide, suivi d'une évaporation partielle du solvant est la meilleure méthode pour obtenir des dispersions stables concentrées et à répartition uniforme de nanotubes.

On notera également que plus la concentration en nanotubes de carbone est faible, plus les agrégats sont petits. Cependant, on voit à partir de l'exemple 15, qu'on arrive à augmenter la concentration en nanotubes "nus" jusqu'à au moins 5 % en poids par rapport au poids total de la dispersion en obtenant une dispersion satisfaisante, dans un solvant organique.

On a ensuite, à partir de la dispersion XFF013, réalisé une évaporation complète du solvant.

On obtient une poudre constituée de nanotubes séparés. Le mélange peut être redispersé en ajoutant, par exemple 5 ml de xylène sous agitation forte. La dispersion ainsi obtenue est stable et à répartition uniforme.

On a utilisé la dispersion ainsi obtenue pour fabriquer des fibres en polyamide chargées en nanotubes de carbone. Pour ce faire, le polyamide a été dissous dans du xylène, la dispersion de nanotubes obtenue précédemment a été mélangée au polyamide dissous dans le xylène, et le mélange obtenu a été extrudé.

Bien entendu, les **objets ci-dessus ne sont** nullement limitée aux modes de réalisation décrits et illustrés.

Ainsi, bien que les nanotubes de carbone aient été décrits comme des feuilles de graphite enroulées sur elles-mêmes, l'homme de l'art comprendra que l'on pourra traiter de la même façon les nanofibres de carbone et les particules de carbone pour obtenir des dispersions stables et à répartition uniforme dans un solvant organique et dans une matrice polymérique solide.

Egalement, bien que le polymère décrit ait été un copolymère bloc, tout autre polymère pourra être utilisé, en particulier des polymères ramifiés.

### Dans une seconde partie :

L'invention permet de résoudre divers problèmes concernant la conversion photovoltaïque.

L'invention permet de résoudre les divers problèmes techniques énoncés en fournissant pour la première fois un dispositif tel que décrit ci-après. Ce dispositif **constitué par une hétérojonction PN** sert principalement pour la fabrication de cellules photovoltaïques.

L'invention résout les problèmes techniques énoncés par le fait que les nanostructures décrites sont capables d'induire efficacement la conversion photovoltaïque. Cette caractéristique précédente étant due pour partie à la complexation d'un pigment sur la nanostructure mais aussi à la possibilité d'évacuer rapidement la chaleur ainsi que les charges.

Ainsi, selon un premier aspect, l'invention concerne une hétérojonction PN comprenant une structure donneuse d'électrons formée par au moins un polymère conjugué, et une structure accepteuse d'électrons formée par au moins un type de nanostructure tubulaire de carbone, les deux structures étant en contact l'une avec l'autre, la nanostructure tubulaire comportant une couche d' au moins un pigment directement adsorbé sur leur périphérie et au moins un polymère ayant un point d'ancrage sur la couche de pigment, le point d'ancrage consistant en des interactions de type Van der Waals.

Avantageusement, les nanostructures tubulaires sont choisies parmi les nanotubes de carbone mono-feuillets (SWNTs), droits et/ou courbés, double-feuillets (DWNTs), droits et/ou courbés, et les nanotubes de carbone multi-feuillets (MWNTs), droits et/ou courbés, et un mélange quelconque de ceux-ci.

Dans cette deuxième partie uniquement, les inventeurs entendent par nanotube de carbone (SWNTs, DWNTs, MWNTs) les structures formées essentiellement d'atomes de carbone liés entre eux formant une molécule sensiblement cylindrique et généralement terminée aux extrémités par une forme semi-sphérique, également constituée principalement d'atomes de carbone liés entre eux. Ces nanotubes de carbone ne forment pas nécessairement une structure parfaite. Dans ce cadre, il est possible de considérer, par exemple, que les nanotubes de carbone multi-feuillets (MWNTs) forment une sorte de nanofibre ou nanofibrile, quand ces nanotubes de carbone multi-feuillets ont un diamètre relativement important.

Les nanostructures possèdent un caractère électronégatif, mais les traitements suivants permettant de les rendre encore plus électronégatives sont très intéressants pour obtenir les propriétés recherchées.

Les nanostructures tubulaires peuvent être halogénées ou oxydées (thermiquement ou chimiquement).

Elles peuvent également comporter des groupements plus complexes, greffés sur la surface extérieure des nanostructures. Ces groupements peuvent être linéaires ou branchés. Ces groupements comprennent généralement des atomes de carbone mais également des hétéroatomes tels que l'azote, le souffre, l'oxygène, le phosphore ainsi que tous les groupements fonctionnels bien connus de l'homme de l'art, notamment, tel que les groupements éther, ester, acide carboxylique, amide, amine, carbamate, hydroxyle, isocyanate, halogène.

Avantageusement, pour augmenter la conductivité électrique de la nanostructure tubulaire, on peut lui faire subir un traitement choisi parmi le groupe consistant en le dopage au bore des nanotubes de carbone, ce dopage pouvant être obtenu sur les nanotubes multi-feuillets lors de la synthèse par décharge électrique, par exemple, entre les électrodes BN et graphite, ou par substitution partielle des atomes de carbone par des atomes de bore sur les nanotubes mono-feuillets, par exemple, par B₂O₃ (gaz) sous atmosphère d'azote à 1500-1700 K.

Avantageusement, la nanostructure tubulaire peut subir un traitement pour améliorer sa processabilité, tel que l'oxydation chimique ou thermique des nanostructures carbonées.

Ces nanostructures tubulaires possèdent une structure de carbone telle que décrite précédemment sur laquelle un pigment est **i.e**. adsorbé. Cette **adsorption ou** complexation est effectuée de préférence de manière similaire à celle décrite ci-dessus dans la première partie de **la description**.

Les pigments sont préférentiellement choisis parmi les pigments azo, les pigments monoazo jaune et orange, les pigments diazo, les pigments napthol, les pigments Napthol® AS (Napthol rouge), les laques de pigment azo, les pigments benzimidazolone, les pigments de condensation diazo, les pigments complexes de métal, les pigments isoindolinone et isoindoline, les pigments polycycliques, les pigments phtalocyanine, une phtalocyanine de cuivre sulfonée contenant, en moyenne, 0,5 à 3 groupes d'acide sulfonique, une phtalocyanine de cuivre chlorée, une phtalocyanine d'aluminium, une phtalocyanine bromée, une phtalocyanine d'aluminium, une pthalocyanine sans métal, les pigments quinophthalone, les pigments indathrone, les pigments diacrylide jaune, les pigments diazopyrozolione, les pigments azo-métal, les pigments triarylcarbonium, pigments rhodamine laque, les pigments pérylène, les pigments quinacridone et les pigments dicétopyrrolopyrrole, et les molécules de porphyrine ou ses dérivés et les mélanges de deux ou plus de tous les pigments précédemment cités.

L'invention concerne également un mélange quelconque de nanotubes **sur lesquels sont adsorbés** des pigments.

L'adsorption de pigments sur les nanotubes permet d'améliorer l'absorption de certaines longueurs d'onde de la lumière incidente. On peut ainsi élargir le spectre d'absorption induisant des états excités et ainsi maximiser la conversion de l'énergie lumineuse en énergie électrique au sein de la cellule.

Avantageusement, l'**adsorbtion** de pigments à la surface des nanostructures contribue additionnellement à la dispersion homogène des nanostructures tubulaires dans la matrice de polymère conjugué.

Avantageusement, les nanostructures tubulaires servent de centres de dissociation des états excités (piège à électrons) des molécules excitées de pigment.

Avantageusement, les nanostructures tubulaires fournissent un réseau conducteur aux électrons apportés par les molécules excitées de pigment.

Avantageusement la phase destinée à former la structure accepteuse d'électrons peut éventuellement contenir un ou plusieurs composants, tels que le carbone amorphe, le graphite, les molécules cages comprenant du carbone tel que les fullerènes, un ou plusieurs catalyseur(s) tels que le nickel, l'yttrium, le cobalt, le calcium, le fer, le platine, le palladium et qui sont notamment des résidus de la réaction de synthèse des nanotubes.

Les nanostructures permettent également d'améliorer la dissipation de chaleur provenant de l'exposition de la cellule à une source lumineuse grâce à leur conductivité thermique. Les nanostructures employées ont une forme fibrillaire ayant un facteur de forme important et une dimension minimale typique inférieure à 200 nanomètres. Ces caractéristiques géométriques confèrent notamment une grande surface inter-faciale entre le polymère conjugué et les nanostructures, ce qui permet de résoudre les problèmes techniques précédemment énoncés.

Avantageusement, le diamètre typique des nanostructures tubulaires est compris dans la gamme nanométrique, de préférence compris entre 0,5 et 200 nanomètres, les nanostructures étant les nanotubes de carbone, notamment ceux ayant, pour les nanotubes de carbone mono-feuillets, un facteur de forme supérieur à 150, et pour les nanotubes de carbone multi-feuillets un facteur de forme privilégié supérieur à 5.

Le facteur de forme est défini comme étant le rapport entre la longueur typique et le diamètre typique de la structure. Les nanostructures décrites sont tubulaires et peuvent être creuses ou pleines et sont essentiellement constituées d'atomes de carbone.

Le diamètre typique des nanotubes mono-feuillets est généralement compris entre environ 0,4 et 4 nanomètres. Le diamètre typique des nanotubes multi-feuillets est généralement compris entre environ 1,4 et au moins 100 nanomètres. Leur longueur est typiquement de plusieurs centaines de nanomètres mais peut atteindre plusieurs micromètres. Les extrémités des tubes peuvent être ouvertes ou fermées par des structures demi-fulleroïdales.

Avantageusement, les nanostructures tubulaires fonctionnent comme une structure accepteuse d'électrons lorsqu'on les dépose sur un substrat ou bien lorsqu'on les mélange avec un polymère conjugué.

Le dispositif de la présente invention nécessite également une structure donneuse d'électrons **formée par** des polymères conjugués. "Par polymère conjugué", les inventeurs entendent tous les polymères semi-conducteurs présentant un système d'électrons Π délocalisés. Une gamme de polymères adéquats, non-limitative, est la suivante :

Les polyacétylènes, polyparaphénylènes, les sulfides de polypyrrols, les sulfides de polyparaphénylène, les polythiophènes, les poly(phénylène vinylène), le poly-3 methylthiophène, le polycarbazole, le polyisothianaphène, le poly(1,6-heptadiyne), le poly-3alkylthiophène, dont l'alkyle est notamment choisi en C₁-C₅, le poly(3,4-ethylènedioxythiophène) ou PEDOT, la polyquinoline, le poly-3alkylsulfonate, dont le groupement alkyle est notamment choisi en C₁-C₅, et la polyaniline et ses dérivés. Les polymères préférés sont de la famille des poly(phénylène vinylène) (PPV)et des poly(3 octyl thiophène).

Cependant, l'invention n'est pas limitée à ces polymères conjugués et peut être réalisée en utilisant d'autres polymères conjugués. Notamment la structure donneuse d'électrons peut être un polymère conjugué pur, un mélange de plusieurs polymères conjugués ou un co-polymère de polymère conjugué.

La surface inter-faciale entre la structure accepteuse d'électrons et la structure donneuse d'électrons doit être la plus grande possible afin de maximiser le nombre de sites de dissociation.

**Le** dispositif de la présente invention forme une hétérojonction PN.

Avantageusement, ce dispositif constitué par le contact entre les nanostructures décrites et le polymère conjugué forme la partie centrale et essentielle de la cellule photovoltaïque.

Selon un second aspect, l'invention concerne un procédé de fabrication d'un dispositif **constitué par une hétérojonction PN** comprenant au moins un polymère conjugué (formant une structure donneuse d'électrons) et des nanostructures **de carbone**. Ce procédé comprend la formation d'une structure accepteuse d'électrons **formée par** au moins un type de nanostructure tubulaire **de carbone**, choisies parmi celles décrites ci-dessus.

Avantageusement, les nanotubes sont formés par des techniques de décharge électrique entre électrodes de carbone [D.S. Bethune, C.H. Kiang, M.S. De Vries, G. Gorman, R. Savoy, Nature 363, 605 (1993) ainsi que C. Journet,W.K. Maser, P. Bernier, A. Loiseau, M. Lamy de la Chapelle, S. Lefrant, P. Deniard, R. Lee, J.E. Fisher, Nature 388, 756 (1997)], d'ablation laser, de dépôt chimique en phase vapeur (CVD) tel que décrit dans les publications suivantes : M.J. Yacaman, M.M. Yoshida, L. Rendon, J.G. Santesban, Appl. Phys. Lett. 62, 202 (1993) ou H. Dai, A.G. Rinzler, P. Nikolaev, A. Thess, D.T. Colbert, R.E. Smalley, Chem. Phys. Lett. 260, 471 (1996) ou bien des techniques de dispropornation de monoxyde de carbone [WO 0026138A1: Gas-Phase Nucleation and growth of Single-Wall Carbon Nanotubes from high-pressure CO], ou toute autre technique similaire.

Avantageusement, la structure donneuse d'électrons comprenant le polymère conjugué est formée par une technique choisie parmi le groupe consistant en les techniques de mise en forme après fusion du polymère (telle que l'extrusion à chaud, le pressage à chaud), de mise en forme à partir d'une solution (tel que le couchage), de polymérisation radicalaire ou anionique ou d'électro-polymérisation, et toute autre technique similaire.

Dans un premier mode de réalisation, le dispositif est formé par au moins une structure accepteuse d'électrons et une structure donneuse d'électrons, discernables entre elles, le dispositif **étant** formé par une couche donneuse d'électrons en contact avec une couche accepteuse d'électrons.

Avantageusement, la structure accepteuse d'électrons comprenant la nanostructure tubulaire est assemblée sous forme de "papier" ou mât de nanotubes, par dépôt à partir d'une suspension comprenant les nanostructures tubulaires décrites précédemment. Cette suspension de nanotubes possédant des pigments adsorbés peut être obtenue comme décrit précédemment. Le dépôt peut se faire, par exemple, par filtration frontale de la suspension de nanostructures tubulaires complexées dans le solvant. La partie solide restant sur le filtre forme une sorte de papier autosupporté, typiquement de quelques dizaines de micromètres d'épaisseur, et principalement composé de nanostructures tubulaires complexées. Le solvant résiduel peut être évaporé si nécessaire. La formulation de la solution de nanotubes **possédant** des pigments **adsorbés** contient également un polymère liant. Le polymère liant sert à faire interagir pigment et solvant et à mettre en suspension. L'arrangement des nanostructures tubulaires dans le mât de nanotubes est alors aléatoire dans le plan conférant une anisotropie planaire.

Le liant est généralement un co-polymère bloc tel que décrit plus haut.

Avantageusement, la structure accepteuse d'électrons comprenant des nanostructures tubulaires assemblées sous forme de "papier" ou mât de nanotubes et qui sera mise ultérieurement en contact avec la structure donneuse d'électrons comprenant notamment le polymère conjugué, subit un traitement pour augmenter la surface de contact avec la structure donneuse d'électrons.

Avantageusement, l'augmentation de la surface de contact s'effectue par toute méthode permettant de faire sortir les nanostructures du plan, comme par exemple, le polymère liant est ôté sur une fraction de l'épaisseur de la couche conductrice afin de laisser émerger les nanostructures, cette opération pouvant être réalisée par une attaque, ou une combinaison d'attaques, chimique, photonique, tel que laser ou UV, particulaire, tel que bombardement électronique ou ionique, ou mécanique telle que l'abrasion.

Avantageusement, une couche auto-supportée de papier de nanostructures tubulaires peut servir directement d'électrode dans une cellule photovoltaïque.

Avantageusement, une couche de métal, préférentiellement de l'aluminium ou de l'or peut être évaporée sur la couche auto-supportée de papier de nanostructures tubulaires pour diminuer encore la résistance de contact entre l'électrode collectrice d'électrons et le circuit extérieur.

Avantageusement, la structure donneuse d'électrons est déposée à partir d'une solution de polymère(s) conjugué(s), ou à partir de polymère(s) conjugué(s) fondu(s), ou bien formée par polymérisation ou électro-polymérisation à partir de l'imprégnation, totale ou partielle, de la couche de nanostructures par un monomère précurseur, ou à partir de tout autre préparation similaire. Les polymères conjugués préférés dans ce dernier cas sont la polyaniline et le polypyrrol.

Avantageusement, le dépôt de cette structure donneuse d'électrons est réalisé par injection, dépôt à la tournette (spin coating), procédé de production continu à rouleaux (roll to roll). Le polymère conjugué peut imprégner, partiellement ou totalement, la couche de nanostructures.

De manière générale, la structure donneuse d'électrons formant une couche comprenant au moins un polymère conjugué doit avoir une épaisseur permettant aux ondes électromagnétiques d'atteindre les sites de dissociation.

De préférence, la couche donneuse d'électrons a une épaisseur d'environ 200 nm.

De préférence, la couche accepteuse d'électrons a une épaisseur d'environ 150 nm

Dans un second mode de réalisation avantageux, le dispositif est une structure composite formée par la dispersion de nanostructures tubulaires au sein du polymère conjugué.

Dans ce mode de réalisation les nanostructures dispersées dans le polymère conjugué forment préférentiellement un réseau conducteur d'électrons permettant d'acheminer les électrons depuis les sites de dissociation jusqu'à la cathode. Les électrons peuvent cheminer sur ce réseau via les nanostructures et par « saut » (hopping) entre celles-ci.

Avantageusement, les nanostructures tubulaires, de par leur longueur importante, permettent l'acheminement des électrons vers la cathode en minimisant - ou même en annulant, le nombre de sauts entre nanostructures, qui est le mode de conduction limitant l'efficacité du transport électronique. Le réseau conducteur d'électrons constitue alors la structure accepteuse d'électrons.

Avantageusement, la structure composite est réalisée par mélange en solution desdites nanostructures complexées par des pigments, tels que précédemment décrits , préalablement dispersée , avec le polymère conjugué dans une solution organique (selon le procédé décrit ci-dessus). La dispersion de nanostructures dans le polymère conjugué, à l'état séché, peut être homogène ou suivre un gradient. un gradient de concentration en nanostructures peut être obtenu, par exemple par effet de sédimentation lors d'un procédé de couchage.

Pour ce mode de réalisation, il est avantageux dans le but de fabriquer une cellule photovoltaïque d'isoler l'électrode transparente de la structure composite par une couche de polymère conjugué ne contenant pas de nanostructures de l'invention. En effet sans cette isolation il est fréquent que des nanostructures soient en contact direct avec l'électrode conductrice, ce qui créé un court circuit entre les deux électrodes.

De manière générale, la structure composite formant une couche comprenant au moins un polymère conjugué doit avoir une épaisseur permettant aux ondes électromagnétiques d'atteindre les sites de dissociation.

De préférence, structure composite a une épaisseur comprise entre environ 300 et 500 nm.

Avantageusement, le dépôt de cette couche est réalisé par injection, dépôt à la tournette (spin coating), procédé de production continu à rouleaux (roll to roll) ou toute autre méthode similaire.

Selon un troisième aspect, l'invention concerne une cellule photovoltaïque comprenant un dispositif **constitué par une hétérojonction PN** tel que défini précédemment.

Selon un quatrième aspect, l'invention concerne une cellule photovoltaïque comprenant un dispositif **constitué par une hétérojonction PN** formé par un procédé de fabrication tel que défini précédemment.

Selon un cinquième aspect, l'invention concerne une méthode de production d'électricité à partir d'une onde électromagnétique comprenant:
a) l'utilisation d'un dispositif tel que défini précédemment pour effectuer une conversion photovoltaïque

Selon un sixième aspect, la présente invention concerne une méthode de production d'électricité à partir d'une onde électromagnétique comprenant :
a) le contact d'une cellule photovoltaïque telle que définie précédemment avec une onde électromagnétique, notamment émise par le soleil, et
b) la génération d'électricité à partir de ladite cellule photovoltaïque. La cellule photovoltaïque est formée par toute technique connue de l'homme de l'art.

### Illustration de l'utilisation des nanotubes de la présente invention pour la conversion photovoltaïque :

- La figure 5 représente la section d'une cellule photovoltaïque type avec ses différentes couches dont une couche accepteuse d'électrons à base de mât de nanotubes
- La figure 6 représente une structure schématique de la section d'une cellule photovoltaïque comportant une couche composite accepteuse d'électrons à base de nanotubes.

La figure 5 illustre une section d'une cellule photovoltaïque standard,
la cellule photovoltaïque (1A) comprend une couche donneuse d'électrons (10) et une couche accepteuse d'électrons (20). La structure donneuse d'électrons est formée notamment par un polymère conjugué tel que décrit dans la présente invention ou un mélange de polymères conjugués.

Dans l'invention présentée, la couche accepteuse d'électrons (20) est formée notamment par au moins un type de nanostructures tubulaires **de carbone** (22) telle que décrit dans la présente invention, c'est à dire **sur lesquelles sont adsorbés** à sa surface au moins un pigment (illustré en figure 1). Après synthèse des nanotubes de carbone, par exemple, par les méthodes connues de l'arc électrique, par ablation laser ou par déposition chimique en phase vapeur, les entités accepteuses d'électrons sont formées par **adsorbtion** de pigments **sur** les nanotubes. **L'adsorbtion** peut être réalisée selon une méthode avantageuse de mélange mécanique intime puis les nanostructures résultantes peuvent être mises en solution tel que décrit ci-dessus. A cette solution est ajouté un liant (21). Une solution de nanostructures tubulaires en suspension est ensuite déposée sur l'électrode (30) par une méthode choisie parmi le dépôt à la tournette (spin-coating), impression par jet d'encre (ink-jet printing), et/ou procédé de production continu à rouleaux (roll to roll). Ainsi la couche (20) contient les nanostructures tubulaires mélangées à un liant (21). La couche (10) est soit déposée à partir d'une solution de polymères conjugués ou bien à partir de polymères conjugués fondus ou à partir de toute autre préparation similaire, soit réalisé par imprégnation de polymères conjugués, partielle ou totale sur la couche de nanostructures tubulaires, de manière à recouvrir en totalité la partie accepteuse d'électrons (20).

L'ensemble, structure donneuse d'électrons (10) et structure accepteuse d'électrons (20) forme une hétérojonction PN.

La structure accepteuse d'électrons (20) est en contact avec l'électrode conductrice électrique (30) qui est généralement opaque et métallique (aluminium, etc).

La structure donneuse d'électrons (10) est en contact avec une électrode transparente électriquement conductrice (40). Habituellement, la lumière permettant le fonctionnement de la cellule photovoltaïque est dirigée vers l'électrode transparente (40).

La figure 6 représente schématiquement une section d'une cellule photovoltaïque (1B). Cette structure est identique à celle de la figure 5 excepté le fait que la couche accepteuse d'électrons et la structure donneuse d'électrons forment une seule couche qui est composite. Cette couche composite est formée de nanostructures tubulaires **de carbone** (122) telles que décrites sur la figure 1 qui forment un réseau conducteur d'électrons dans la matrice de polymère conjugué (110). Cette structure accepteuse d'électrons (120) est en contact avec une électrode conductrice électrique (130). Cette structure (120) est également en contact avec une structure donneuse d'électrons (150) formée essentiellement par un polymère conjugué seul ou un mélange de polymères conjugués. Cette couche de polymère(s) conjugué(s) permet d'éviter un court-circuit entre l'électrode (130) et l'électrode transparente conductrice (140). Un tel mode de réalisation permet l'utilisation de nanostructures tubulaires à fort rapport de forme permettant en particulier le transport direct des électrons depuis le lieu de dissociation de l'exciton vers l'électrode (130). D'autre part, l'utilisation de ces nanostructures tubulaires permet le transport balistique des électrons. Cette structure composite (120) peut être formée de diverses façons. Notamment, les nanostructures peuvent être dispersées aléatoirement ou orientées dans le cas de l'application d'une force de cisaillement mécanique ou d'un champs électrique ou magnétique.

La dispersion aléatoire de nanostructures tubulaires est effectuée par mélange en solution avec le polymère conjugué ou à partir de polymère conjugué fondu, ou par polymérisation ou électropolymérisation du polymère conjugué, ou par toute autre technique similaire. La dispersion de nanostructures tubulaires dans le polymère conjugué peut être homogène ou suivre un gradient. Par exemple un gradient de concentrations peut être obtenue par sédimentation des structures tubulaires les plus « grandes », les plus lourdes : la force figure 5 excepté le fait que la couche accepteuse d'électrons et la structure donneuse d'électrons forment une seule couche qui est composite. Cette couche composite est formée de nanostructures tubulaires (122) telles que décrites sur la figure 1 qui forment un réseau conducteur d'électrons dans la matrice de polymère conjugué (110). Cette structure accepteuse d'électrons (120) est en contact avec une électrode conductrice électrique (130). Cette structure (120) est également en contact avec une structure donneuse d'électrons (150) formée essentiellement par un polymère conjugué seul ou un mélange de polymères conjugués. Cette couche de polymère(s) conjugué(s) permet d'éviter un court-circuit entre l'électrode (130) et l'électrode transparente conductrice (140). Un tel mode de réalisation permet l'utilisation de nanostructures tubulaires à fort rapport de forme permettant en particulier le transport direct des électrons depuis le lieu de dissociation de l'exciton vers l'électrode (130). D'autre part, l'utilisation de ces nanostructures tubulaires permet le transport balistique des électrons. Cette structure composite (120) peut être formée de diverses façons. Notamment, les nanostructures peuvent être dispersées aléatoirement ou orientées dans le cas de l'application d'une force de cisaillement mécanique ou d'un champs électrique ou magnétique.

La dispersion aléatoire de nanostructures tubulaires est effectuée par mélange en solution avec le polymère conjugué ou à partir de polymère conjugué fondu, ou par polymérisation ou électropolymérisation du polymère conjugué, ou par toute autre technique similaire. La dispersion de nanostructures tubulaires dans le polymère conjugué peut être homogène ou suivre un gradient. Par exemple un gradient de concentrations peut être obtenue par sédimentation des structures tubulaires les plus « grandes », les plus lourdes : la force gravitationnelle prenant alors le pas sur les interactions de type électrostatiques.

D'autres buts, caractéristiques et avantages de l'invention apparaîtront clairement à l'homme de l'art suite à la lecture de la description explicative qui fait référence à des exemples qui sont donnés seulement à titre d'illustration et qui ne sauraient en aucune façon limiter la portée de l'invention.

Les exemples ci-après font partie intégrante de la présente invention et d'autres caractéristiques apparaissant nouvelles par rapport à un état de la technique antérieure quelconque à partir de la description prise dans son ensemble, incluant les exemples, font partie intégrante de l'invention dans sa fonction et dans sa généralité.

Ainsi, chaque exemple a une portée générale.

### EXEMPLES D'UTILISATIONS SELON L'INVENTION DES NANOTUBES POUR LA CONVERSION PHTOVOLTAÏQUE:

Dans les exemples 16 à 21, le polymère conjugué peut être la polyaniline ou le poly(paraphénylène vinylène).

### Exemple 16 : Formation selon l'invention d'une structure accepteuse d'électrons sous forme de mât de nanotubes à partir de nanostructures tubulaires :

Les structures accepteuses d'électrons sont formées en utilisant la méthode de l'arc électrique. Deux électrodes de graphite sont placées face à face dans une enceinte préalablement mis sous vide puis remplie d'un gaz inerte. L'anode est constituée d'un barreau de graphite contenant des catalyseurs métalliques (Nickel, Yttrium ou autre mélange de terres rares) mobile en translation supporté par un ensemble conducteur, la cathode est un bloc de graphite mobile refroidi à l'eau.

Une fois le système mis sous tension, l'anode est approchée suffisamment de la cathode pour pouvoir générer un arc lors du passage du courant. L'anode est par la suite maintenue à une distance de l'ordre de quelques millimètres. L'énergie dissipée par effet Joule dans l'anode échauffe le barreau jusqu'à sublimation du graphite. La formation de l'arc s'accompagne de la création d'un plasma dont la température peut atteindre 6000K. Pendant la synthèse, l'anode est continuellement translatée dans la direction de la cathode au fur et à mesure de l'érosion, de façon à garder constante la distance inter-électrodes.

La production de nanotubes mono-feuillets s'opère de façon classique, dans une enceinte d'hélium voir d'argon sous une dépression d'environ 5.10⁴ Pa, avec une tension de l'ordre de 30 V et une intensité proche de 100 A.

Ces nanostructures sont ensuite enrobées par des pigments selon le procédé décrit dans la présente invention aux exemples 1 à 15.

La structure accepteuse d'électrons est alors assemblée sous forme de "papier" ou mât de nanotubes à partir d'une suspension de nanotubes complexés. Ce papier est, par exemple, obtenu par filtration frontale de la suspension. Ceci conduit à la formation sur le filtre d'une couche de nanostructures dont l'épaisseur peut être contrôlée par la quantité et la concentration de la suspension employée. Cette étape peut être suivie facultativement par une étape de rinçage. Un « papier » autosupporté peut être alors ôté du filtre et séché. NB : Lors de la filtration, la suspension de nanostructures peut être avantageusement maintenue homogène par agitation de la solution.

### Exemple 17 : Formation selon l'invention d'une structure accepteuse d'électrons à partir de nanostructures tubulaires, éventuellement comprenant un liant :

Une structure d'accepteuse d'électrons peut être formée à partir d'une suspension de nanotubes de carbone mono-feuillet **sur lesquels sont adsorbés un pigment** comprenant un liant, tels que ceux mentionnés dans les exemples 1 à 15. Dans ce cas, la structure accepteuse d'électrons peut être avantageusement déposée sur un support, tel une électrode conductrice lors de la réalisation d'une cellule photovoltaïque, par spin-coating (dépôt à la tournette). Cette étape est suivie d'une étape de séchage destinée à évacuer le solvant résiduel. L'opération de dépôt à la tournette et de séchage peut facultativement être répétée un nombre voulu de fois.
Avantageusement, l'emploi d'un polymère liant permet de stabiliser la suspension de nanotubes de carbone mono-feuillet **sur lesquels sont adsorbés un pigment** et d'augmenter sa viscosité, ce qui élargit la gamme de réalisations possibles_par la méthode de dépôt à la tournette.

Le rapport massique nanostructures /polymère liant peut excéder 1.

### Exemple 18 : Formation d'une structure accepteuse d'électrons basée sur des nanotubes de carbone traités

Les nanotubes de carbone peuvent être dopés au bore afin d'augmenter leur conductivité électrique. Par exemple, ce dopage peut s'effectuer par substitution partielle sur les nanotubes mono-feuillets, par B₂O₃ (gaz) sous atmosphère d'azote à 1500-1700 K, comme décrit dans B. Goldberg et al. Carbon 38 (2000) 2017.

Alternativement, ou bien complémentairement, les nanotubes de carbone peuvent être traités afin d'augmenter leur électronégativité, suivant les méthodes d'halogénation et d'oxydation décrites dans L. Duclaux, Carbon 40(2002)1751 et références incluses.

Sur les nanotubes **est** ensuite **adsorbé** un pigment comme décrit dans les exemples 1 à 15.

Les procédures de formation d'un papier de nanotubes (exemple 16) et de films de nanotube comprenant un liant (exemple 17) peuvent ensuite être suivies.

### Exemple 19 : Formation d'une structure accepteuse d'électrons basée sur des nanotubes de carbone greffés.

Des traitements tels que ceux décrits dans le brevet US 2002/004028 A1 ou dans la publication Chem. Mater. 14 (2002) 1472-1476 permettent d'augmenter le caractère électrophile des nanotubes en greffant des nucléophiles à la surface des nanotubes.

Sur les nanotubes **est** ensuite **adsorbé** un pigment comme décrit dans les exemples 1 à 15.

Les procédures de formation d'un papier de nanotubes (exemple 16) et de films de nanotube comprenant un liant (exemple 17) peuvent être ensuite suivies.

### Exemple 20 : Formation d'une hétérojonction PN comportant deux couches distinctes :

La structure accepteuse d'électrons décrite dans l'exemple 1 est recouverte par une couche de polymère conjugué à partir d'une solution de ce polymère, par la technique de dépôt à la tournette. Préférentiellement la couche de polymère conjugué est inférieure à 100 nm. Une couche semi transparente d'aluminium (inférieure à 100 nanomètres) est ensuite déposée par évaporation sur la face opposée à celle de la structure accepteuse d'électrons afin de constituer une électrode. L'autre électrode peut être directement constituée par le papier autosupporté de nanotubes ou bien par tout report conducteur électronique sur celui-ci.

Alternativement, la structure accepteuse d'électrons décrite dans l'exemple 17 est préparée sur un substrat conducteur en oxyde mixte d'indium et d'étain (Indium Tin Oxide) ITO. Avantageusement, le polymère liant est dégradé au moins superficiellement par traitement thermique (chauffage sous vide à haute température). Une fine couche (préférentiellement inférieure à 100 nm) de polymère conjugué est ensuite déposée sur ce dispositif par déposition à la tournette à partir d'une solution de ce polymère conjugué. Une couche semi transparente d'aluminium (inférieure à 100 nanomètres) est ensuite déposée par évaporation sur la face opposée à celle de l'ITO afin de constituer la seconde électrode.

Alternativement encore, une fine couche (préférentiellement inférieure à 100 nm) de polymère conjugué est déposée sur un substrat ITO par dépôt à la tournette à partir d'une solution de ce polymère conjugué. La structure accepteuse d'électrons est préparée sur ce dispositif comme décrit en exemple 17. Le dispositif est ensuite séché sous vide à l'étuve afin d'extraire le solvant, mais à température modérée. Une couche d'aluminium de quelques centaines de nanomètres est ensuite déposée par évaporation sur la face opposée à celle de l'ITO afin de constituer l'autre électrode.

### Exemple 21 : Formation d'une hétérojonction PN comportant une couche composite :

Une fine couche (préférentiellement inférieure à 100 nm) de polymère conjugué est déposée sur un substrat ITO par dépôt à la tournette à partir d'une solution de ce polymère conjugué. Cette préparation est laissée quelque minutes à température ambiante, dans un dessiccateur, sous azote.

Les nanotubes de carbone (mono ou multi feuillets) après avoir été mélangés mécaniquement intimement au pigment selon la méthode décrite dans les exemples 1 à 15 sont incorporés et mélangés à une autre solution de ce même polymère conjugué. Cette préparation est déposée par spin coating sur le substrat précédemment obtenu. Un soin particulier afin d'éviter toute contamination par de la poussière doit être porté lors de cette élaboration. L'opération de dépôt/séchage peut être renouvelé un nombre souhaité de fois après quelque minutes de séchage sous azote. Le dispositif est ensuite séché sous vide à l'étuve afin d'extraire le solvant, mais à température modérée.

Une couche d'aluminium de quelques centaines de nanomètres est ensuite déposée par évaporation sur la face opposée à celle de l'ITO afin de constituer l'autre électrode.

## Revendications

1. Hétérojonction PN comprenant une structure donneuse d'électrons (10) formée par au moins un polymère conjugué, et une structure accepteuse d'électrons (20) formée par au moins un type de nanostructure tubulaire de carbone (1), les deux structures étant en contact l'une avec l'autre, **caractérisée en ce que** la nanostructure tubulaire (1) comporte une couche d'au moins un pigment (3) directement adsorbé sur leur périphérie externe (2) et au moins un polymère (5) ayant un point d'ancrage sur la couche de pigment (3), le point d'ancrage consistant en des interactions de type Van der Waals.

2. Hétérojonction PN selon la revendication 1 ou 2, **caractérisée en ce que** la nanostructure tubulaire (1) est choisie parmi le groupe consistant en les nanotubes de carbone mono-feuillet (SWNTs), droits et/ou courbés, doubles-feuillets (DWNTs), droits et/ou courbés, et les nanotubes de carbone multi-feuillets (MWNTs), droits et/ou courbés, et un mélange quelconque de ceux-ci.

3. Hétérojonction PN selon la revendication 1 ou 2, **caractérisée en ce que** le pigment (3) adsorbé sur la nanostructure tubulaire est choisi parmi les pigments azo, les pigments monoazo jaune et orange, les pigments diazo, les pigments napthol, les pigments napthol® AS (napthol rouge), les laques de pigment azo, les pigments benzimidazolone, les pigments de condensation diazo, les pigments complexes de métal, les pigments isoindolinone et isoindoline, les pigments polycycliques, les pigments phtalocyanine, une phtalocyanine de cuivre sulfonéee contenant, en moyenne, 0,5 à 3 groupes d'acide sulfonique, une phtalocyanine de cuivre chlorée, une phtalocyanine d'aluminium, une phtalocyanine bromée, une phtalocyanine d'aluminium, une pthalocyanine sans métal, les pigments quinophthalone, les pigments indathrone, les pigments diacrylide jaune, les pigments diazopyrozolione, les pigments azo-métal, les pigments triarylcarbonium, pigments rhodamine laque, les pigments pérylène, les pigments quinacridone et les pigments dicétopyrrolopyrrole et les molécules de porphyrine ou ses dérivés et les mélanges de deux ou plus de tous ceux-ci.

4. Hétérojonction PN, selon l'une quelconque des revendications précédentes, **caractérisée en ce que** le diamètre typique des nanostructures (1) considérées est dans la gamme nanométrique, de préférence compris entre 0,5 et 200 nanomètres, les nanostructures préférées étant les nanotubes de carbone, ayant, pour les nanotubes de carbone mono-feuillet, un facteur de forme privilégié supérieur à 150, et pour les nanotubes de carbone multi-feuillets, un facteur de forme privilégié supérieur à 5.

5. Hétérojonction PN, selon l'une quelconque des revendications précédentes, **caractérisée en ce que** le polymère (5) lié à ladite couche d'au moins un pigment (3) est un copolymère bloc d'acide hydroxyoctadécanoïque et d'aziridine.

6. Hétérojonction PN, selon la revendication 5, **caractérisée en ce que** le rapport en poids nanotubes/pigment/polymère est compris entre 1/1/1 et 1/5/1.

7. Hétérojonction PN, selon l'une quelconque des revendications précédentes, **caractérisée en ce que** le pigment (3) est la phtalocyanine.

8. Hétérojonction PN, selon l'une quelconque des revendications précédentes, **caractérisée en ce que** le polymère conjugué est choisi parmi le groupe consistant en les polyacétylènes, polyparaphénylènes, les sulfides de polypyrrols, les sulfides de polyparaphénylène, les polythiophènes, les poly(phénylène vinylène), le poly-3 methylthiophène, le polycarbazole, le polyisothianaphène, le poly(1,6-heptadiyne), le poly-3alkylthiophène, dont l'alkyle est notamment choisi en C₁-C₅, le poly(3,4-ethylènedioxythiophène) ou PEDOT, la polyquinoline, le poly-3alkylsulfonate, dont le groupement alkyle est notamment choisi en C₁-C₅, la polyaniline et ses dérivés, et de préférence les poly(phénylène vinylène) et les poly(3octylthiophène).

9. Hétérojonction PN, selon l'une quelconque des revendications précédentes, **caractérisée en ce que** la nanostructure tubulaire fonctionne comme une structure accepteuse d'électrons en mélange avec un polymère liant, de préférence le polymère liant représente moins de 50% en poids de la structure accepteuse d'électrons.

10. Hétérojonction PN, selon l'une quelconque des revendications précédentes **caractérisée en ce que** la structure accepteuse d'électrons et la structure donneuse d'électrons sont discernables entre elles ou forment une structure composite.

11. Hétérojonction PN selon la revendication 10 **caractérisée en ce que** la structure accepteuse d'électrons et la structure donneuse d'électrons sont discernables entre elles, l'hétérojonction PN comprenant une couche de structure accepteuse d'électrons recouverte par une couche de structure donneuse d'électrons.

12. Hétérojonction PN selon la revendication 10 **caractérisée en ce que** la structure accepteuse d'électrons et la structure donneuse d'électrons forment une structure composite par dispersion de la structure accepteuse d'électrons au sein d'une matrice constituée par la structure donneuse d'électrons.

13. Procédé de fabrication d'une hétérojonction PN telle que définie à la revendication 11 **caractérisé en ce qu'**il comprend
- une étape de formation d'une structure accepteuse d'électrons formée par au moins un type de nanostructure tubulaire de carbone (1) comprenant une couche d'au moins un pigment (3) directement adsorbé sur leur périphérie externe (2) et au moins un polymère (5) ayant un point d'ancrage sur la couche de pigment (3), le point d'ancrage consistant en des interactions de type Van der Waals, lesdites nanostructures tubulaires étant assemblées sous forme de papier ou mât de nanotubes, par dépôt à partir d'une suspension comprenant des nanostructures tubulaires, et
- Une étape de mise en contact de la structure accepteuse d'électrons avec la structure donneuse d'électrons par dépôt à partir d'une solution de polymère conjugué ou bien à partir de polymère conjugué fondu, , le dépôt étant réalisé par injection ou dépôt à la tournette (spin coating).

14. Procédé de fabrication d'une hétérojonction PN telle que définie à la revendication 12, **caractérisée en ce que** la structure composite est réalisée par mélange en solution des nanostructures tubulaires avec le polymère conjugué ou par voie fondue, la dispersion de nanostructures dans le polymère conjugué pouvant être homogène ou suivre un gradient.

15. Cellule photovoltaïque **caractérisée en ce qu'**elle comprend une hétérojonction PN telle que définie aux revendications 1 à 12.

## Patentansprüche

1. PN-Heteroübergang, umfassend eine Elektronen abgebende Struktur (10), die durch wenigstens ein konjugiertes Polymer gebildet ist, sowie eine Elektronen aufnehmende Struktur (20), die durch wenigstens eine Art einer röhrenförmigen Kohlenstoff-Nanostruktur (1) gebildet ist, wobei die beiden Strukturen miteinander in Kontakt sind, **dadurch gekennzeichnet, dass** die röhrenförmige Nanostruktur (1) eine Schicht aus wenigstens einem Pigment (3), das direkt an ihrem Außenumfang (2) adsorbiert ist, und wenigstens ein Polymer (5), das eine Verankerungsstelle an der Pigmentschicht (3) aufweist, umfasst, wobei die Verankerungsstelle aus Wechselwirkungen vom Typ Van-der-Waals besteht.

2. PN-Heteroübergang nach Anspruch 1, **dadurch gekennzeichnet, dass** die röhrenförmige Nanostruktur (1) aus der Gruppe bestehend aus den geraden und/oder gebogenen einwandigen Kohlenstoff-Nanoröhren (SWNT), den geraden und/oder gebogenen doppelwandigen Kohlenstoff-Nanoröhren (DWNT) und den geraden und/oder gebogenen mehrwandigen Kohlenstoff-Nanoröhren (MWNT) sowie einer beliebigen Mischung aus diesen ausgewählt ist.

3. PN-Heteroübergang nach Anspruch 1 oder 2, **dadurch gekennzeichnet, dass** das an der röhrenförmigen Nanostruktur adsorbierte Pigment (3) ausgewählt ist aus den Azopigmenten, den Monoazopigmenten Gelb und Orange, den Diazopigmenten, den Naphthol-Pigmenten, den Naphthol® AS-Pigmenten (Naphtholrot), den Azopigmentlacken, den Benzimidazolon-Pigmenten, den Diazokondensationspigmenten, den Metallkomplex-Pigmenten, den Isoindolinon- und Isoindolin-Pigmenten, den polycyclischen Pigmenten, den Phthalocyanin-Pigmenten, einem sulfonierten Kupferphthalocyanin, das im Durchschnitt 0,5 bis 3 Sulfonsäuregruppen enthält, einem chlorierten Kupferphthalocyanin, einem bromierten Phthalocyanin, einem Aluminium-Phthalocyanin, einem metallfreien Phthalocyanin, den Chinophthalon-Pigmenten, den Indanthron-Pigmenten, den Diacrylid-Gelb-Pigmenten, den Diazopyrozolion-Pigmenten, den Azo-Metall-Pigmenten, den Triarylcarbonium-Pigmenten, den Rhodamin-Lack-Pigmenten, den Perylen-Pigmenten, den Chinacridon-Pigmenten und den Diketopyrrolopyrrol-Pigmenten und den Porphyrin-Molekülen oder ihren Derivaten sowie den Mischungen aus zwei oder mehr von all diesen.

4. PN-Heteroübergang nach einem der vorhergehenden Ansprüche, **dadurch gekennzeichnet, dass** der typische Durchmesser der betrachteten Nanostrukturen (1) im nanometrischen Bereich liegt, vorzugsweise zwischen 0,5 und 200 Nanometer beträgt, wobei die bevorzugten Nanostrukturen die Kohlenstoff-Nanoröhren sind, mit einem bevorzugten Formfaktor größer als 150 für die einwandigen Kohlenstoff-Nanoröhren und einem bevorzugten Formfaktor größer als 5 für die mehrwandigen Kohlenstoff-Nanoröhren.

5. PN-Heteroübergang nach einem der vorhergehenden Ansprüche, **dadurch gekennzeichnet, dass** das mit der Schicht aus wenigstens einem Pigment (3) verbundene Polymer (5) ein Blockcopolymer aus Hydroxyoctadecansäure und Aziridin ist.

6. PN-Heteroübergang nach Anspruch 5, **dadurch gekennzeichnet, dass** das Gewichtsverhältnis Nanoröhren/Pigment/Polymer zwischen 1/1/1 und 1/5/1 liegt.

7. PN-Heteroübergang nach einem der vorhergehenden Ansprüche, **dadurch gekennzeichnet, dass** das Pigment (3) Phthalocyanin ist.

8. PN-Heteroübergang nach einem der vorhergehenden Ansprüche, **dadurch gekennzeichnet, dass** das konjugierte Polymer ausgewählt ist aus der Gruppe bestehend aus den Polyacetylenen, Polyparaphenylenen, den Polypyrrolsulfiden, den Polyparaphenylensulfiden, den Polythiophenen, Poly(phenylen-vinylen), Poly-3-methylthiophen, Polycarbazol, Polyisothianaphen, Poly(1,6-heptadiin), Poly-3-Alkylthiophen, dessen Alkyl insbesondere als C₁-C₅- gewählt ist, Poly(3,4-ethylendioxythiophen) oder PEDOT, Polychinolin, Poly-3-alkylsulfonat, dessen Alkylgruppe insbesondere als C₁-C₅- gewählt ist, Polyanilin und seinen Derivaten sowie vorzugsweise Poly(phenylen-vinylen) und Poly(3-octylthiophen).

9. PN-Heteroübergang nach einem der vorhergehenden Ansprüche, **dadurch gekennzeichnet, dass** die röhrenförmige Nanostruktur wie eine Elektronen aufnehmende Struktur in Mischung mit einem bindenden Polymer funktioniert, wobei vorzugsweise das bindende Polymer weniger als 50 Gew.-% der Elektronen aufnehmenden Struktur ausmacht.

10. PN-Heteroübergang nach einem der vorhergehenden Ansprüche, **dadurch gekennzeichnet, dass** die Elektronen aufnehmende Struktur und die Elektronen abgebende Struktur voneinander unterscheidbar sind oder eine Verbundstruktur bilden.

11. PN-Heteroübergang nach Anspruch 10, **dadurch gekennzeichnet, dass** die Elektronen aufnehmende Struktur und die Elektronen abgebende Struktur voneinander unterscheidbar sind, wobei der PN-Heteroübergang eine Schicht aus Elektronen aufnehmender Struktur, die mit einer Schicht aus Elektronen abgebender Struktur überzogen ist, umfasst.

12. PN-Heteroübergang nach Anspruch 10, **dadurch gekennzeichnet, dass** die Elektronen aufnehmende Struktur und die Elektronen abgebende Struktur eine Verbundstruktur durch Verteilen der Elektronen aufnehmenden Struktur innerhalb einer durch die Elektronen abgebende Struktur gebildeten Matrix bilden.

13. Verfahren zur Herstellung eines PN-Heteroübergangs, wie er in Anspruch 11 definiert ist, **dadurch gekennzeichnet, dass** es umfasst:
- einen Schritt zur Bildung einer Elektronen aufnehmenden Struktur, die durch wenigstens eine Art von röhrenförmiger Kohlenstoff-Nanostruktur (1) gebildet ist, die eine Schicht aus wenigstens einem Pigment (3), das direkt an ihrem Außenumfang (2) adsorbiert ist, und wenigstens ein Polymer (5) umfasst, das eine Verankerungsstelle an der Pigmentschicht (3) aufweist, wobei die Verankerungsstelle aus Wechselwirkungen vom Typ Van-der-Waals besteht, wobei die röhrenförmigen Nanostrukturen in Form von Nanoröhren-Papier oder -Matte, durch Abscheiden aus einer röhrenförmige Nanostrukturen umfassenden Suspension, zusammengefügt sind, und
- einen Schritt zum Inkontaktbringen der Elektronen aufnehmenden Struktur mit der Elektronen abgebenden Struktur durch Abscheiden aus einer Lösung von konjugiertem Polymer oder aber aus geschmolzenem konjugiertem Polymer, wobei das Abscheiden durch Spritzen oder Schleuderbeschichten (spin coating) vollzogen wird.

14. Verfahren zur Herstellung eines PN-Heteroübergangs, wie er in Anspruch 12 definiert ist, **dadurch gekennzeichnet, dass** die Verbundstruktur durch Mischen in Lösung der röhrenförmigen Nanostrukturen mit dem konjugierten Polymer oder auf dem Schmelzweg hergestellt wird, wobei die Verteilung von Nanostrukturen in dem konjugierten Polymer homogen sein oder einem Gradienten folgen kann.

15. Photovoltaikzelle, **dadurch gekennzeichnet, dass** sie einen PN-Heteroübergang, wie er in den Ansprüchen 1 bis 12 definiert ist, umfasst.

## Claims

1. A PN heterojunction comprising an electron donor structure (10) formed by at least one conjugated polymer, and an electron acceptor structure (20) formed by at least one type of carbon tubular nanostructure (1), both structures being in contact with one another, the PN heterojunction being **characterized in that** the tubular nanostructure (1) has a layer of at least one pigment (3) directly adsorbed on its outer periphery (2), and at least one polymer (5) having an anchoring point on the layer of pigment (3), the anchoring point consisting of interactions of the van der Waals type.

2. A PN heterojunction according to claim 1, **characterized in that** the tubular nanostructure (1) is selected from the group consisting of straight and/or bent single-wafer, double-wafer and multi-wafer carbon nanotubes (SWNT, DWNT and MWNT) and any mixture of these.

3. A PN heterojunction according to claim 1 or claim 2, **characterized in that** the pigment (3) adsorbed on the tubular nanostructure is selected from azo pigments, yellow and orange monoazo pigments, diazo pigments, naphthol pigments, Naphthol^{®} AS pigments (naphthol red), azo pigment lakes, benzimidazolone pigments, diazo condensation pigments, complex metal pigments, isoindolinone and isoindoline pigments, polycyclic pigments, phthalocyanine pigments, a sulfonated copper phthalocyanine containing an average of 0.5 to 3 sulfonic acid groups, a chlorinated copper phthalocyanine, a brominated phthalocyanine, an aluminum phthalocyanine, a metal-free phthalocyanine, quinophthalone pigments, indathrone pigments, yellow diacrylide pigments, diazopyrazolone pigments, azo-metal pigments, triarylcarbonium pigments, rhodamine lake pigments, perylene pigments, quinacridone pigments and diketopyrrolopyrrole pigments, molecules of porphyrin or derivatives thereof, and mixtures of two or more of all these.

4. A PN heterojunction according to any one of the preceding claims, **characterized in that** the typical diameter of the nanostructures (1) in question is in the nanometer range and preferably between 0.5 nanometers and 200 nanometers, the preferred nanostructures being carbon nanotubes, with, for the single-wafer carbon nanotubes a preferred form factor of more than 150 and for the multi-wafer carbon nanotubes a preferred form factor of more than 5.

5. A PN heterojunction according to any one of the preceding claims, **characterized in that** the polymer (5) bound to said layer of at least one pigment (3) is a hydroxyoctadecanoic acid and aziridine block copolymer.

6. A PN heterojunction according to claim 5, **characterized in that** the weight ratio nanotubes/pigment/polymer is between 1/1/1 and 1/5/1.

7. A PN heterojunction according to any one of the preceding claims, **characterized in that** the pigment (3) is phthalocyanine.

8. A PN heterojunction according to any one of the preceding claims, **characterized in that** the conjugated polymer is selected from the group comprising polyacetylenes, polyparaphenylenes, polypyrrole sulfides, polyparaphenylene sulfides, polythiophenes, polyphenylene vinylenes, poly-3-methylthiophene, polycarbazole, polyisothianaphthene, poly(1,6-heptadiyne), poly-3-alkylthiophene in which the chosen alkyl is especially C₁-C₅, poly(3,4-ethylenedioxythiophene) or PEDOT, polyquinoline, poly-3-alkylsulfonate in which the chosen alkyl group is especially C₁-C₅, and polyaniline and derivatives thereof, preferably polyphenylene vinylenes and poly(3-octylthiophenes).

9. A PN heterojunction according to any one of the preceding claims, **characterized in that** the tubular nanostructure functions as an electron acceptor structure mixed with a binding polymer, the binding polymer preferably representing less than 50% by weight of the electron acceptor structure.

10. A PN heterojunction according to any one of the preceding claims, **characterized in that** the electron acceptor structure and the electron donor structure are mutually discernible or form a composite structure.

11. A PN heterojunction according to claim 10, **characterized in that** the electron acceptor structure and the electron donor structure are mutually discernible, with the PN heterojunction comprising a layer of electron acceptor structure that is coated with a layer of electron donor structure.

12. A PN heterojunction according to claim 10, **characterized in that** the electron acceptor structure and the electron donor structure form a composite structure by dispersion of the electron acceptor structure within the matrix constituted by the electron donor structure.

13. A process for the manufacture of a PN heterojunction as defined in claim 11 **characterized in that** it comprises
- a step for forming an electron acceptor structure formed by at least one type of carbon tubular nanostructure (1) which in turn comprises a layer of at least one pigment (3) directly adsorbed on its outer periphery (2) and at least one polymer (5) having an anchoring point on the layer of pigment (3), the anchoring point consisting of interactions of the van der Waals type, said tubular nanostructures being assembled in the form of a paper or mat of nanotubes, by deposition from a suspension containing tubular nanostructures; and
- a step for bringing the electron acceptor structure into contact with the electron donor structure by deposition from a solution of conjugated polymer or from molten conjugated polymer, deposition being effected by injection or spin coating.

14. A manufacturing process of a PN heterojunction as defined in claim 12, **characterized in that** the composite structure is produced by mixing, in solution, tubular nanostructures with the conjugated polymer, or by a molten method, it being possible for the dispersion of nanostructures in the conjugated polymer to be homogeneous or to follow a gradient.

15. A photovoltaic cell, **characterized in that** it includes a PN heterojunction as defined in claims 1 to 12.
